# EUROPEAN PATENT APPLICATION

(11) **EP 4 447 115 A1**
(43) Date of publication of application: **16.10.2024**
(21) Application number: 22903954.0
(22) Date of filing: 09.11.2022
(51) Int. Cl.: H01L 27/146, H04N 25/76, H04N 25/778

(54) **PHOTODETECTION DEVICE AND ELECTRONIC APPARATUS**

(30) Priority: 10.12.2021 JP 2021201045
(71) Applicant: Sony Semiconductor Solutions Corporation, Atsugi-shi, Kanagawa 243-0014 (JP)
(72) Inventor: SHIMADA, Shohei, Atsugi-shi, Kanagawa 243-0014 (JP); SEKINE, Ryotaro, Atsugi-shi, Kanagawa 243-0014 (JP); MURASE, Takuro, Atsugi-shi, Kanagawa 243-0014 (JP); OTAKE, Yusuke, Atsugi-shi, Kanagawa 243-0014 (JP); WAKANO, Toshifumi, Atsugi-shi, Kanagawa 243-0014 (JP)
(74) Representative: MFG Patentanwälte Meyer-Wildhagen Meggle-Freund Gerhard PartG mbB
(86) International application number: PCT/JP2022/041749
(87) International publication number: WO 2023/106023

(57) **Abstract**

The present technology provides a photodetection device in which an increase in capacitance of charge accumulation regions is prevented. The photodetection device includes: a first semiconductor layer; a first wiring layer; a second wiring layer; and a second semiconductor layer, the first semiconductor layer including: a cell region in which a photoelectric conversion element is formed; a charge storage region; and a transfer transistor, the first wiring layer including a first wiring line group and a second wiring line group stacked on the first wiring line group via an insulating film, the first wiring line group being the wiring line group located closest to the first semiconductor layer, the first wiring line group including a first pad, a reference potential line, and a gate control line that are provided at intervals in a horizontal direction, the second wiring line group including a second pad electrically connected to the first pad, the first wiring layer including: a first via having one end connected to the charge accumulation region and the other end connected to the first pad; a second via having one end connected to the cell region and the other end connected to the reference potential line; and a third via having one end connected to the gate electrode of the transfer transistor and the other end connected to the gate control line.

## Description

### TECHNICAL FIELD

The present technology (technology according to the present disclosure) relates to a photodetection device and an electronic apparatus, and more particularly, to a photodetection device in which a plurality of semiconductor layers is stacked, and an electronic apparatus.

### BACKGROUND ART

As a photodetection device in which a plurality of semiconductor layers is stacked, there is a photodetection device disclosed in Patent Document 1, for example. In this photodetection device, a sensor pixel disposed on a first substrate and a readout circuit disposed on a second substrate are electrically connected to each other by bonding of junction electrodes.

### CITATION LIST

### PATENT DOCUMENT

Patent Document 1: Japanese Patent Application Laid-Open No. 2020-88380

### SUMMARY OF THE INVENTION

### PROBLEMS TO BE SOLVED BY THE INVENTION

The present technology aims to provide a photodetection device and an electronic apparatus capable of preventing an increase in capacitance of charge accumulation regions (floating diffusions).

### SOLUTIONS TO PROBLEMS

A photodetection device according to one aspect of the present technology includes a stack structure in which a first semiconductor layer, a first wiring layer, a second wiring layer, and a second semiconductor layer are stacked in this order, the first semiconductor layer including: a cell region in which a photoelectric conversion element is formed; a charge accumulation region; and a transfer transistor that is provided for each photoelectric conversion element and is capable of transferring a signal charge generated by the photoelectric conversion element to the charge accumulation region, the first wiring layer including: a first wiring line group; and a second wiring line group stacked on the first wiring line group with an insulating film being interposed in between, the first wiring line group being a wiring line group located closest to the first semiconductor layer, the first wiring line group including: a first pad; a reference potential line; and a gate control line provided at intervals in a horizontal direction, the second wiring line group including a second pad that faces a surface of the first wiring layer on a side of the second wiring layer and is electrically connected to the first pad, the first wiring layer including: a first via having one end connected to the charge accumulation region and the other end connected to the first pad; a second via having one end connected to the cell region and the other end connected to the reference potential line; and a third via having one end connected to a gate electrode of the transfer transistor and the other end connected to the gate control line.

An electronic apparatus according to one aspect of the present technology includes the above photodetection device, and an optical system that causes the photodetection device to form an image with image light from an object.

### BRIEF DESCRIPTION OF DRAWINGS

Fig. 1 is a chip layout diagram illustrating an example configuration of a photodetection device according to a first embodiment of the present technology.
Fig. 2 is a block diagram illustrating an example configuration of the photodetection device according to the first embodiment of the present technology.
Fig. 3 is an equivalent circuit diagram of pixels of the photodetection device according to the first embodiment of the present technology.
Fig. 4A is a longitudinal sectional view of the photodetection device according to the first embodiment of the present technology.
Fig. 4B is a partially enlarged view illustrating the relevant portion of Fig. 4A in an enlarged manner.
Fig. 4C is an explanatory diagram illustrating a positional relationship between pixel sets and a first wiring line group in a planar view in the photodetection device according to the first embodiment of the present technology.
Fig. 4D is an explanatory diagram illustrating a positional relationship between pixel sets and second to fifth pads in a planar view in the photodetection device according to the first embodiment of the present technology.
Fig. 4E is an explanatory diagram illustrating a positional relationship between pixel sets and wiring lines of a second wiring layer in a planar view in the photodetection device according to the first embodiment of the present technology.
Fig. 4F is a plan view illustrating a positional relationship among separation regions and a first pad and first vias in a pixel set in the photodetection device according to the first embodiment of the present technology.
Fig. 5 is a flowchart illustrating a method for manufacturing the photodetection device according to the first embodiment of the present technology.
Fig. 6 is an explanatory diagram illustrating a positional relationship between pixel sets and second to fifth pads in a planar view in a photodetection device according to Modification 1 of the first embodiment of the present technology.
Fig. 7 is an explanatory diagram illustrating a positional relationship between pixel sets and second to fifth pads in a planar view in a photodetection device according to Modification 2 of the first embodiment of the present technology.
Fig. 8A is a plan view of the relevant portion of a photodetection device according to a second embodiment of the present technology.
Fig. 8B is a longitudinal sectional view illustrating a cross-section structure when viewed in cross section taken along the section line B-B defined n Fig. 8A.
Fig. 8C is an explanatory diagram illustrating a positional relationship between pixel sets and second to fifth pads in a planar view in the photodetection device according to the second embodiment of the present technology.
Fig. 9 is a plan view illustrating a positional relationship among separation regions and a first pad and first vias in a pixel set in the photodetection device according to the second embodiment of the present technology.
Fig. 10 is an explanatory diagram illustrating a positional relationship between pixel sets and second to fifth pads in a planar view in a photodetection device according to Modification 1 of the second embodiment of the present technology.
Fig. 11 is an explanatory diagram illustrating a positional relationship between pixel sets and second to fifth pads in a planar view in a photodetection device according to Modification 2 of the second embodiment of the present technology.
Fig. 12A is a plan view illustrating a positional relationship among separation regions and a first pad and a first via in a pixel set in a photodetection device according to a third embodiment of the present technology.
Fig. 12B is a longitudinal sectional view illustrating an example of a cross-section structure of a diffusion separation region.
Fig. 13A is a plan view illustrating a positional relationship among separation regions and a first pad and a first via in a pixel set in a photodetection device according to Modification 1 of the third embodiment of the present technology.
Fig. 13B is a longitudinal sectional view illustrating an example of a cross-section structure of a combination of a full trench separation region and a diffusion separation region.
Fig. 14 is a plan view illustrating a positional relationship among separation regions and a first pad and a first via in a pixel set in a photodetection device according to Modification 2 of the third embodiment of the present technology.
Fig. 15 is a plan view illustrating a positional relationship among separation regions and a first pad and a first via in a pixel set in a photodetection device according to Modification 3 of the third embodiment of the present technology.
Fig. 16 is a plan view illustrating a positional relationship among separation regions and a first pad and a first via in a pixel set in a photodetection device according to Modification 4 of the third embodiment of the present technology.
Fig. 17 is a plan view illustrating a positional relationship among separation regions and a first pad and first vias in a pixel set in a photodetection device according to a fourth embodiment of the present technology.
Fig. 18 is a plan view illustrating a positional relationship among separation regions and a first pad and first vias in a pixel set in a photodetection device according to Modification 1 of the fourth embodiment of the present technology.
Fig. 19 is a plan view illustrating a positional relationship among separation regions and a first pad and first vias in a pixel set in a photodetection device according to Modification 2 of the fourth embodiment of the present technology.
Fig. 20 is a plan view illustrating a positional relationship among separation regions and a first pad and first vias in a pixel set in a photodetection device according to Modification 3 of the fourth embodiment of the present technology.
Fig. 21 is a plan view illustrating a positional relationship among separation regions and a first pad and first vias in a pixel set in a photodetection device according to Modification 4 of the fourth embodiment of the present technology.
Fig. 22 is a plan view illustrating a positional relationship among separation regions and a first pad and first vias in a pixel set in a photodetection device according to Modification 5 of the fourth embodiment of the present technology.
Fig. 23 is a plan view illustrating a positional relationship among separation regions and a first pad and first vias in a pixel set in a photodetection device according to Modification 6 of the fourth embodiment of the present technology.
Fig. 24 is a plan view illustrating a positional relationship among separation regions and a first pad and first vias in a pixel set in a photodetection device according to Modification 7 of the fourth embodiment of the present technology.
Fig. 25 is a plan view illustrating a positional relationship among separation regions and a first pad and first vias in a pixel set in a photodetection device according to Modification 8 of the fourth embodiment of the present technology.
Fig. 26 is a plan view illustrating a positional relationship among separation regions and a first pad and first vias in a pixel set in a photodetection device according to Modification 9 of the fourth embodiment of the present technology.
Fig. 27 is a plan view illustrating a positional relationship among separation regions and a first pad and first vias in a pixel set in a photodetection device according to Modification 10 of the fourth embodiment of the present technology.
Fig. 28 is a plan view illustrating a positional relationship among separation regions and a first pad and first vias in a pixel set in a photodetection device according to Modification 11 of the fourth embodiment of the present technology.
Fig. 29 is a plan view illustrating a positional relationship among separation regions and a first pad and first vias in a pixel set in a photodetection device according to Modification 12 of the fourth embodiment of the present technology.
Fig. 30 is a plan view illustrating a positional relationship among separation regions and a first pad and first vias in a pixel set in a photodetection device according to Modification 13 of the fourth embodiment of the present technology.
Fig. 31 is a plan view illustrating a positional relationship among separation regions and a first pad and first vias in a pixel set in a photodetection device according to Modification 14 of the fourth embodiment of the present technology.
Fig. 32 is a plan view illustrating a positional relationship among separation regions and a first pad and first vias in a pixel set in a photodetection device according to Modification 15 of the fourth embodiment of the present technology.
Fig. 33 is a plan view illustrating a positional relationship among separation regions and a first pad and first vias in a pixel set in a photodetection device according to Modification 16 of the fourth embodiment of the present technology.
Fig. 34 is a plan view illustrating a positional relationship among separation regions and a first pad and first vias in a pixel set in a photodetection device according to Modification 17 of the fourth embodiment of the present technology.
Fig. 35A is a view illustrating the structure of a transistor included in a photodetection device according to a fifth embodiment of the present technology.
Fig. 35B is a view illustrating the structure of a transistor included in a photodetection device according to the fifth embodiment of the present technology.
Fig. 35C is a view illustrating the structure of a transistor included in a photodetection device according to the fifth embodiment of the present technology.
Fig. 35D is a view illustrating the structure of a transistor included in a photodetection device according to the fifth embodiment of the present technology.
Fig. 36 is a view illustrating the structure of bonding portions included in a photodetection device according to a sixth embodiment of the present technology.
Fig. 37 is a view illustrating the structure of bonding portions included in a photodetection device according to Modification 1 of the sixth embodiment of the present technology.
Fig. 38 is a diagram illustrating a schematic configuration of an electronic apparatus according to a seventh embodiment of the present technology.
Fig. 39 is a block diagram illustrating an example of a schematic configuration of a vehicle control system.
Fig. 40 is an explanatory diagram illustrating an example of installation positions of an outside-vehicle information detecting section and imaging sections.
Fig. 41 is a diagram illustrating an example of a schematic configuration of an endoscopic surgery system.
Fig. 42 is a block diagram illustrating an example of the functional configurations of a camera head and a CCU.

### MODE FOR CARRYING OUT THE INVENTION

The following is a description of preferred embodiments for carrying out the present technology, with reference to the drawings. Note that embodiments described below each illustrate an example of a representative embodiment of the present technology, and the scope of the present technology is not narrowed by them.

In the following explanation of the drawings, the same or similar components are denoted by the same or similar reference signs. It should be noted that the drawings are schematic, and a relationship between a thickness and a planar dimension, a ratio of the thicknesses between the respective layers, and the like are different from actual ones. Therefore, specific thicknesses and dimensions should be determined in consideration of the following description. Also, it is needless to say that the drawings include portions having different dimensional relationships and ratios.

Further, the embodiments described below each relate to an example of a device or a method for embodying the technical idea of the present technology, and the technical idea of the present technology does not limit the materials, shapes, structures, layouts, and the like of the components to those described below. Various changes can be made to the technical idea of the present technology within the technical scope defined by the claims disclosed in the claims.

Explanation will be made in the following order.
1. First Embodiment
2. Second Embodiment
3. Third Embodiment
4. Fourth Embodiment
5. Fifth Embodiment
6. Sixth Embodiment
7. Seventh Embodiment

Example Application to an Electronic Apparatus

Example Application to a Mobile Structure

Example Application to an Endoscopic Surgery System

### [First Embodiment]

In a first embodiment, an example in which the present technology is applied to a photodetection device that is a back-illuminated complementary metal oxide semiconductor (CMOS) image sensor is described.

### <<Overall Configuration of a Photodetection Device>>

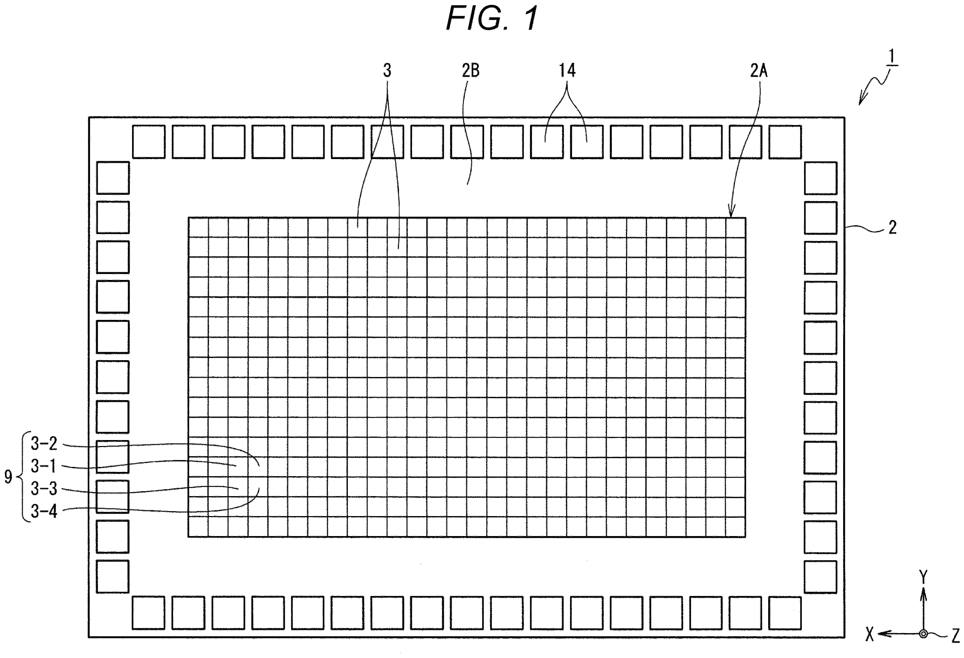

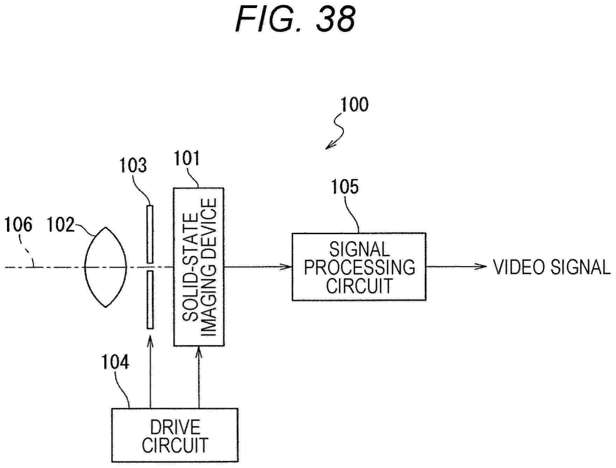

First, an overall configuration of a photodetection device 1 is described. As illustrated in Fig. 1, the photodetection device 1 according to the first embodiment of the present technology is formed mainly with a semiconductor chip 2 having a rectangular two-dimensional planar shape in a planar view. That is, the photodetection device 1 is mounted on the semiconductor chip 2. As illustrated in Fig. 38, the photodetection device 1 captures image light (incident light 106) from the object via an optical system (optical lens) 102, converts the amount of the incident light 106 formed as an image on the imaging surface into an electrical signal pixel by pixel, and outputs the electrical signal as a pixel signal.

As illustrated in Fig. 1, the semiconductor chip 2 on which the photodetection device 1 is mounted includes, in a two-dimensional plane including an X direction and a Y direction intersecting each other, a rectangular pixel region 2A provided in a central portion, and a peripheral region 2B provided outside the pixel region 2A to surround the pixel region 2A.

The pixel region 2A is a light receiving surface that receives light condensed by an optical system 102 illustrated in Fig. 38, for example. Further, in the pixel region 2A, a plurality of pixels 3 is arranged in a matrix in the two-dimensional plane including the X direction and the Y direction. In other words, the pixels 3 are repeatedly disposed in each of the X direction and the Y direction intersecting each other in the two-dimensional plane. Note that, in the present embodiment, the X direction and the Y direction are orthogonal to each other, for example. Furthermore, a direction orthogonal to both the X direction and the Y direction is a Z direction (thickness direction). A direction perpendicular to the Z direction is a horizontal direction. Although the present embodiment is described on the assumption that the X direction is the row direction while the Y direction is the column direction, the X direction may be the column direction while the Y direction is the row direction.

Further, among the plurality of pixels 3 arranged in the pixel region 2A, a plurality of pixels 3 constitutes one pixel set 9. In the pixel region 2A, a plurality of pixel sets 9 is arranged in a matrix in the two-dimensional plane including the X direction and the Y direction. Fig. 1 illustrates an example of one pixel set 9 among the plurality of pixel sets 9. One pixel set 9 includes, but is not limited to, four pixels 3 arranged in two rows and two columns, for example. Note that the number of pixels constituting one pixel set 9 is not necessarily four. Further, the four pixels 3 included in one pixel set 9 are referred to as pixels 3-1, 3-2, 3-3, and 3-4, to be distinguished from one another. In a case where the pixels 3-1, 3-2, 3-3, and 3-4 are not distinguished, they are simply referred to as the pixels 3.

As illustrated in Fig. 1, a plurality of bonding pads 14 is disposed in the peripheral region 2B. Each bonding pad of the plurality of bonding pads 14 is disposed along each of the four sides of the two-dimensional plane of the semiconductor chip 2, for example. Each bonding pad of the plurality of bonding pads 14 is an input-output terminal that is used when the semiconductor chip 2 is electrically connected to an external device.

### <Logic Circuit>

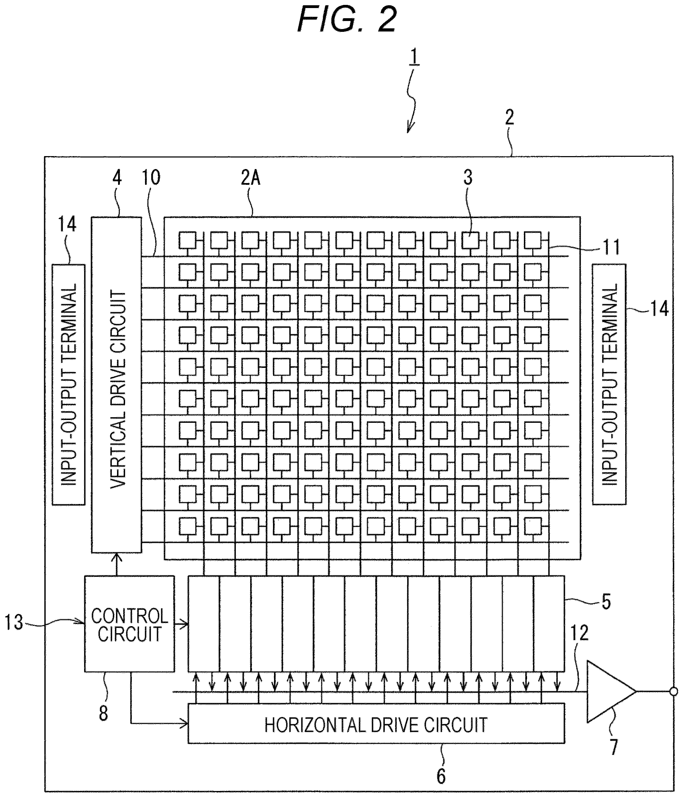

As illustrated in Fig. 2, the semiconductor chip 2 includes a logic circuit 13 including a vertical drive circuit 4, column signal processing circuits 5, a horizontal drive circuit 6, an output circuit 7, a control circuit 8, and the like. The logic circuit 13 includes a complementary MOS (CMOS) circuit including an n-channel conductive metal oxide semiconductor field effect transistor (MOSFET) and a p-channel conductive MOSFET as field effect transistors, for example.

The vertical drive circuit 4 includes a shift register, for example. The vertical drive circuit 4 sequentially selects a desired pixel drive line 10, supplies a pulse for driving the pixels 3 to the selected pixel drive line 10, and drives the respective pixels 3 row by row. That is, the vertical drive circuit 4 selectively scans each of the pixels 3 in the pixel region 2A sequentially in a vertical direction on a row-by-row basis, and supplies a pixel signal from each of the pixels 3 based on a signal charge generated in accordance with the amount of received light by a photoelectric conversion element of the pixel 3 to the column signal processing circuit 5 through a vertical signal line 11.

The column signal processing circuits 5 are disposed on the respective columns of the pixels 3, for example, and perform, for the respective pixel columns, signal processing such as noise removal on signals to be output from the pixels 3 of one row. For example, each column signal processing circuit 5 performs signal processing such as correlated double sampling (CDS) for removing pixel-specific fixed pattern noise, and analog-to-digital (AD) conversion. A horizontal selection switch (not shown) is disposed in the output stage of each column signal processing circuit 5, and is connected to a horizontal signal line 12.

The horizontal drive circuit 6 includes a shift register, for example. The horizontal drive circuit 6 sequentially outputs horizontal scanning pulses to the column signal processing circuits 5 to sequentially select each of the column signal processing circuits 5, and causes each of the column signal processing circuits 5 to output a pixel signal subjected to signal processing to the horizontal signal line 12.

The output circuit 7 performs signal processing on pixel signals sequentially supplied from the respective column signal processing circuits 5 through the horizontal signal line 12, and outputs a processed signal. As the signal processing, buffering, black level adjustment, column variation correction, various kinds of digital signal processing, and the like can be used, for example.

The control circuit 8 generates a clock signal and a control signal that are references for operations of the vertical drive circuit 4, the column signal processing circuits 5, the horizontal drive circuit 6, and the like, on the basis of a vertical synchronization signal, a horizontal synchronization signal, and a master clock signal. The control circuit 8 then outputs the generated clock signal and control signal to the vertical drive circuit 4, the column signal processing circuits 5, the horizontal drive circuit 6, and the like.

### <Pixels>

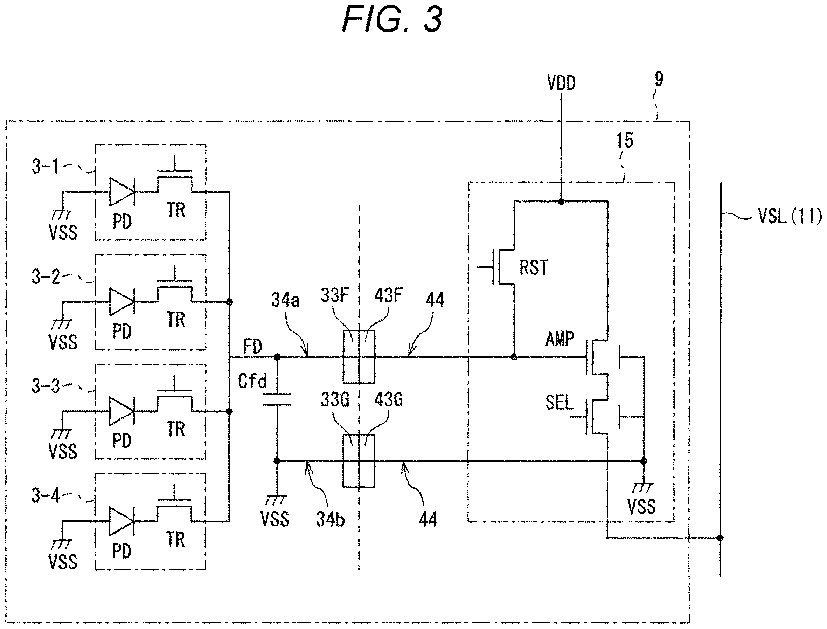

Fig. 3 is an equivalent circuit diagram illustrating an example configuration of a pixel set 9 including the pixels 3-1, 3-2, 3-3, and 3-4. The pixel set 9 includes, in each pixel 3, a photoelectric conversion element PD, a charge accumulation region (floating diffusion) FD that accumulates (holds) a signal charge photoelectrically converted by the photoelectric conversion element PD, and a transfer transistor TR that transfers the signal charge photoelectrically converted by the photoelectric conversion element PD to the charge accumulation region FD. The pixel set 9 also includes one readout circuit 15 electrically connected to the charge accumulation region FD. Further, the four pixels 3 included in the pixel set 9 share the one readout circuit 15. That is, the outputs of the plurality of pixels 3 belonging to the same set are input to one readout circuit 15. Although the control is not limited to this, when the transfer transistors TR of the pixels 3-1, 3-2, 3-3, and 3-4 are sequentially controlled, for example, the outputs of the plurality of pixels 3 belonging to the same set are sequentially input to one readout circuit 15.

Each photoelectric conversion element PD generates a signal charge Q corresponding to the amount of received light. The photoelectric conversion element PD also temporarily accumulates (holds) the generated signal charge. Each photoelectric conversion element PD has its cathode side electrically connected to the source region of the transfer transistor TR, and its anode side electrically connected to a reference potential line described later. As the photoelectric conversion elements PD, photodiodes are used, for example. A reference potential (the ground, for example) VSS is designed to be applied to the reference potential line.

The drain region of each transfer transistor TR is electrically connected to the charge accumulation region FD. The gate electrode of each transfer transistor TR is electrically connected to a transfer transistor drive line among the pixel drive lines 10 (see Fig. 2).

The charge accumulation region FD temporarily accumulates and holds signal charges transferred from the photoelectric conversion elements PD via the transfer transistors TR. The charge accumulation region FD is connected to the input end of the readout circuit 15 via a first via 34a, a second pad 33F, a third pad 43F, a via 44, and the like described later. Also, in the charge accumulation region FD, a capacitance Cfd is generated between the charge accumulation region FD and the reference potential VSS. When the capacitance Cfd changes, a voltage value V that is supplied from the charge accumulation region FD to the readout circuit 15 changes. More specifically, the relationship among the voltage value V, the capacitance Cfd, and the signal charge Q generated by the photoelectric conversion element PD can be expressed as Q = Cfd × V. Further, when the capacitance Cfd increases with respect to the signal charge Q of a certain value, the voltage value V decreases.

Also, the reference potential VSS of the reference potential line described later and the reference potential VSS on the side of the readout circuit 15 are electrically conducted via a second via 34b, a fourth pad 33G, a fifth pad 43G, the via 44, and the like described later.

The readout circuit 15 reads the signal charge accumulated in the charge accumulation region FD, and outputs a pixel signal based on the signal charge. Although not limited to this, the readout circuit 15 includes an amplification transistor AMP, a selection transistor SEL, and a reset transistor RST as pixel transistors, for example. Each of these transistors (AMP, SEL, and RST) includes a MOSFET including a gate insulating film formed with a silicon oxide film (SiO₂ film), a gate electrode, and a pair of main electrode regions functioning as the source region and the drain region, for example. Furthermore, each of these transistors may be a metal insulator semiconductor FET (MISFET) whose gate insulating film is a silicon nitride film (Si₃N₄ film) or a film stack of a silicon nitride film and a silicon oxide film.

The amplification transistor AMP has its source region electrically connected to the drain region of the selection transistor SEL, and its drain region electrically connected to a power supply line Vdd and the drain region of the reset transistor. Further, the gate electrode of the amplification transistor AMP is electrically connected to the charge accumulation region FD and the source region of the reset transistor RST.

The selection transistor SEL has its source region electrically connected to the vertical signal line 11 (VSL), and its drain electrically connected to the source region of the amplification transistor AMP. Furthermore, the gate electrode of the selection transistor SEL is electrically connected to a selection transistor drive line among the pixel drive lines 10 (see Fig. 2).

The reset transistor RST has its source region electrically connected to the charge accumulation region FD and the gate electrode of the amplification transistor AMP, and its drain region electrically connected to the power supply line Vdd and the drain region of the amplification transistor AMP. The gate electrode of the reset transistor RST is electrically connected to a reset transistor drive line among the pixel drive lines 10 (see Fig. 2).

### <<Specific Configuration of the Photodetection Device>>

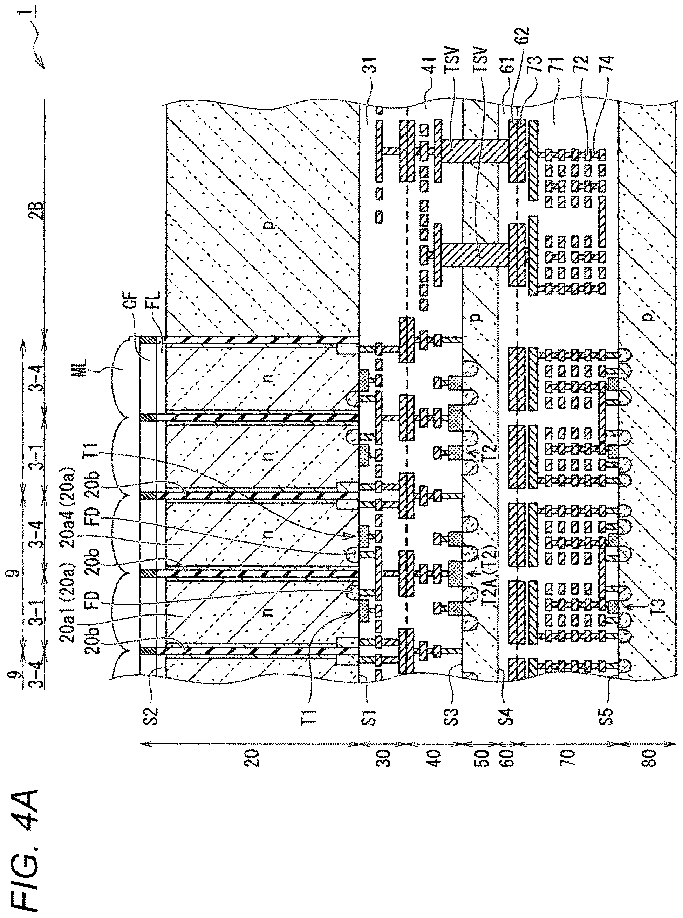

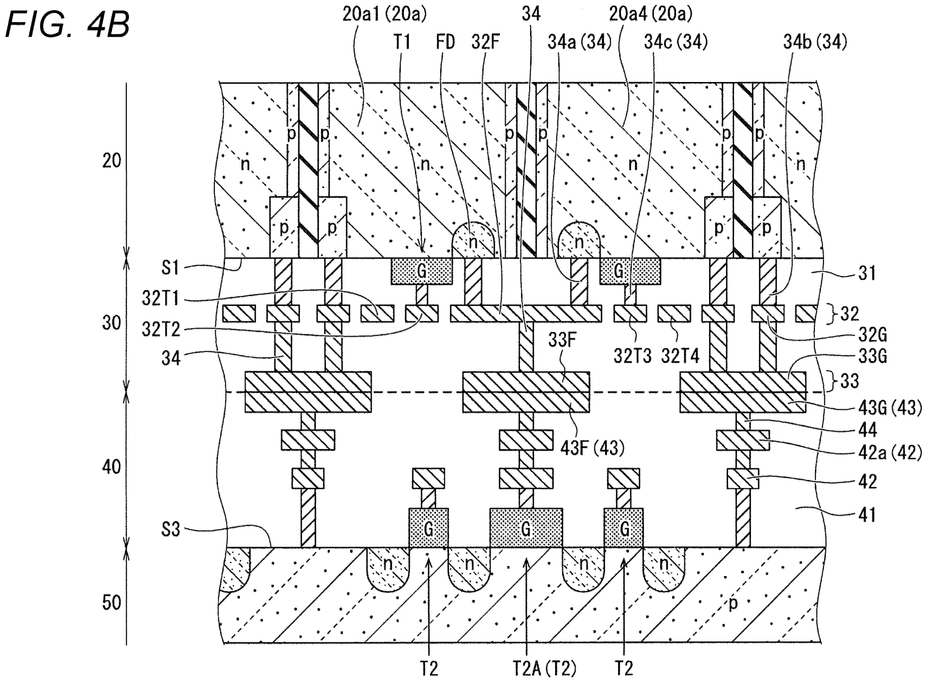

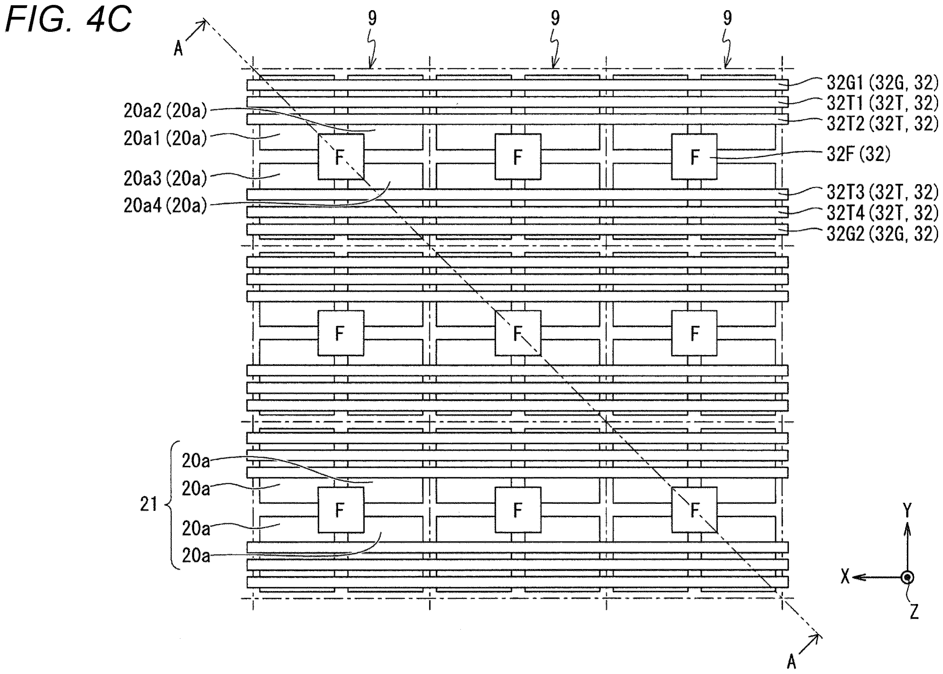

Next, a specific configuration of the photodetection device 1 is described with reference to Figs. 4A to 4F. The pixel set 9 illustrated in Fig. 4A is a cross-section structure when the pixel set 9 illustrated in Figs. 4C to 4E is viewed in cross section along a section line A-A. Fig. 4B is a partially enlarged view illustrating the relevant portion of Fig. 4A in an enlarged manner. Furthermore, in Figs. 4C to 4E, a dot-and-dash line indicates a boundary between pixel sets 9.

### <Stack Structure of the Photodetection Device>

As illustrated in Fig. 4A, the photodetection device 1 (semiconductor chip 2) has a stack structure in which a first semiconductor layer 20, a first wiring layer 30, a second wiring layer 40, a second semiconductor layer 50, a third wiring layer 60, a fourth wiring layer 70, and a third semiconductor layer 80 are stacked in this order.

The first semiconductor layer 20 has a cell region to be described later, one surface being a first surface S1, the other surface being a second surface S2 that is the light entrance face. The first wiring layer 30 is joined to the first surface S1 of the first semiconductor layer 20. The second wiring layer 40 is joined to the surface of the first wiring layer 30 on the opposite side from the surface on the side of the first semiconductor layer 20. The second semiconductor layer 50 includes a plurality of transistors. One surface of the second semiconductor layer 50 is a third surface S3, and the other surface is a fourth surface S4. The third surface S3 is joined to the surface of the second wiring layer 40 on the opposite side from the surface on the side of the first wiring layer 30. The third wiring layer 60 is joined to the fourth surface S4 of the second semiconductor layer 50. The fourth wiring layer 70 is joined to the surface of the third wiring layer 60 on the opposite side from the surface on the side of the second semiconductor layer 50. A fifth surface S5 of the third semiconductor layer 80 is joined to the surface of the fourth wiring layer 70 on the opposite side from the surface on the side of the third wiring layer 60.

The photodetection device 1 (semiconductor chip 2) further includes, on the side of the second surface S2, a planarization film FL, color filters CF, microlenses ML, and the like stacked in this order from the side of the second surface S2, for example, but does not necessarily include these films and the like. The planarization film FL planarizes the side of the second surface S2. The microlenses ML condense light entering the first semiconductor layer 20. The color filters CF perform color separation on light entering the first semiconductor layer 20. The color filters CF and the microlenses ML are provided for the respective pixels 3. In one pixel set 9, the color filters CF are provided in the three colors of red, green, and blue, for example, but are not limited to this. The color filters CF and the microlenses ML are formed with a resin material, for example.

Here, the first surface S1 of the first semiconductor layer 20 may be referred to as the device formation surface or the principal surface, and the second surface S2 of the first semiconductor layer 20 may be referred to as the light entrance face or the back surface. Also, the third surface S3 of the second semiconductor layer 50 may be referred to as the device formation surface or the principal surface, and the fourth surface S4 of the second semiconductor layer 50 may be referred to as the back surface. Further, the fifth surface S5 of the third semiconductor layer 80 may be referred to as the device formation surface or the principal surface, and the surface on the opposite side from the fifth surface S5 may be referred to as the back surface.

### <First Semiconductor Layer>

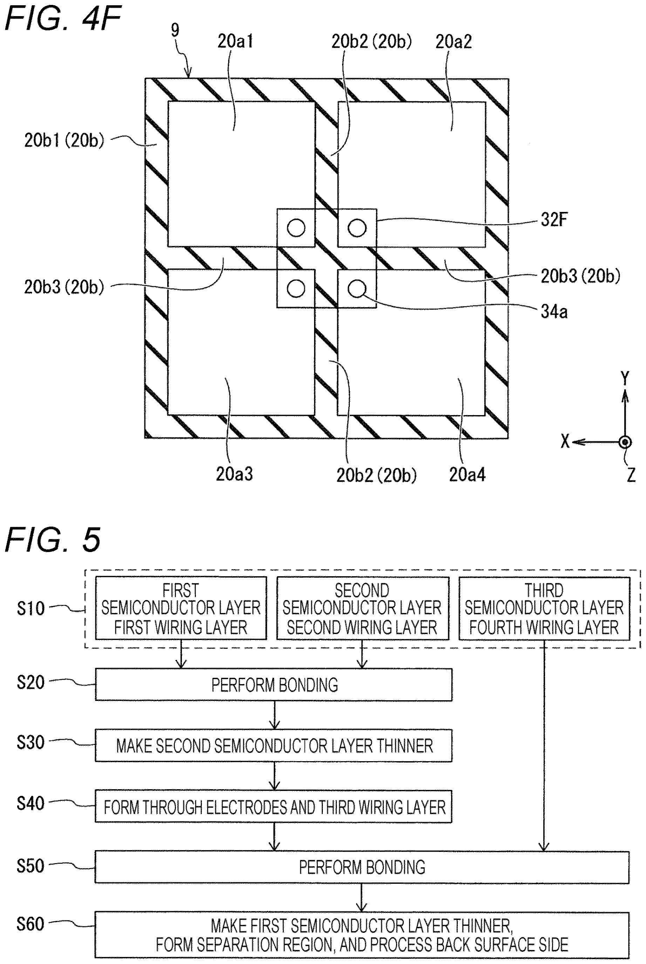

The first semiconductor layer 20 includes a semiconductor substrate. The first semiconductor layer 20 is not limited to this, and is formed with a single-crystal silicon substrate, for example. In a region of the first semiconductor layer 20 overlapping the pixel region 2A in a planar view, a cell region 20a is provided for each pixel 3. For example, as illustrated in Figs. 4A and 4F, island-like cell regions 20a partitioned by separation regions 20b are provided for the respective pixels 3. Note that the number of pixels 3 is not limited to the number shown in Fig. 4A. More specifically, in the first semiconductor layer 20, the cell regions 20a are also electrically connected to reference potential lines 32G to be described later. Each cell region 20a includes a semiconductor region of a first conductivity type (the p-type, for example) and a semiconductor region of a second conductivity type (the n-type, for example), and the photoelectric conversion elements PD illustrated in Fig. 3 are formed in the cell regions 20a. More specifically, one photoelectric conversion element PD is formed for each one cell region 20a.

Each separation region 20b has, but is not limited to, a trench structure in which a separation groove is formed in the first semiconductor layer 20, and a separating material is embedded in the separation groove, for example. In the example illustrated in Fig. 4A, the separation regions 20b are full trench separation regions, and the inside of the separation grooves and the separating material (located between the first surface S1 and the second surface S2) penetrate the first semiconductor layer 20 in the thickness direction. Further, as the separating material, an insulating film may be embedded, or both an insulating film and a metal or the like may be embedded, for example, though the separating material is not limited to this. The present embodiment is described on the assumption that that silicon oxide (SiO2) is embedded as the separating material.

Furthermore, as illustrated in Fig. 4F, the separation regions 20b include a separation region 20b1 that is a portion that separates the pixel sets 9 from one another and surrounds one pixel set 9 in a planar view, a separation region 20b2 that separates the cell regions 20a arranged in the row direction (X direction) in the pixel set 9 from each other, and a separation region 20b3 that separates the cell regions 20a arranged in the column direction (Y direction) in the pixel set 9 from each other. In a case where the separation region 20b1, the separation region 20b2, and the separation region 20b3 are not distinguished from one another, they are simply referred to as the separation regions 20b. The entire regions from the separation region 20b1 to the separation region 20b3 are full trench separation regions.

As illustrated in Fig. 4C, the first semiconductor layer 20 includes a plurality of pixel sets 9. The pixel sets 9 are arranged in the row direction and the column direction. One pixel set 9 includes a plurality of pixels 3. Furthermore, since the cell regions 20a are provided for the respective pixels 3, one pixel set 9 includes a plurality of cell regions 20a in accordance with the number of pixels 3. The plurality of cell regions 20a included in one pixel set 9 constitutes one set 21.

The present embodiment is described on the assumption that one pixel set 9 includes four pixels 3 arranged in two rows and two columns, and one set 21 includes four cell regions 20a arranged in two rows and two columns. Also, to distinguish the four cell regions 20a included in one set 21 from one another, they are referred to as cell regions 20a1, 20a2, 20a3, and 20a4 in some cases. In a case where these cell regions are not distinguished from one another, they are simply referred to as the cell region 20a. Further, the cell region 20a1 corresponds to the pixel 3-1, the cell region 20a2 corresponds to the pixel 3-2, the cell region 20a3 corresponds to the pixel 3-3, and the cell region 20a4 corresponds to the pixel 3-4. Note that the number of cell regions 20a included in one set 21 is not limited to four, and, in some cases, may increase or decrease depending on the number of pixels 3 included in one pixel set 9. Furthermore, dot-and-dash lines indicating the boundaries between the pixel sets 9 also indicate the boundaries between the sets 21. One pixel set 9 (set 21) is rectangular in a planar view. More specifically, one pixel set 9 (set 21) has a square shape in a planar view.

In the first semiconductor layer 20, at least one charge accumulation region FD is provided for each pixel set 9 (set 21). In the present embodiment, the first semiconductor layer 20 has four charge accumulation regions FD for each pixel set 9 (set 21). More specifically, one charge accumulation region FD is provided for each cell region 20a corresponding to each pixel 3 of a pixel set 9. The charge accumulation regions FD are semiconductor regions of the second conductivity type (the n-type, for example), and are disposed in well regions (not shown) that are semiconductor regions of the first conductivity type (the p-type, for example). Furthermore, the four charge accumulation regions FD provided for each pixel set 9 are provided at positions closer to the first surface S1 in the thickness direction, and are provided at positions closer to the center of the pixel set 9 in a planar view.

Transistors are provided in the first semiconductor layer 20. In the first semiconductor layer 20, a transistor T1 is provided for each photoelectric conversion element PD. More specifically, one transistor T1 is provided for each photoelectric conversion element PD. The transistors T1 are the transfer transistors TR shown in Fig. 3. Each transistor T1 can form a channel of the second conductivity type (the n-type, for example) in a well region of the first conductivity type (the p-type, for example), and can transfer a signal charge generated by the photoelectric conversion element PD to the charge accumulation region FD. The gate electrodes G of the transistors T1 are provided in the first wiring layer 30, as illustrated in Fig. 4B.

### <First Wiring Layer>

As illustrated in Fig. 4B, the first wiring layer 30 includes an insulating film 31, a first wiring line group 32 obtained by dividing one metal film, a second wiring line group 33 laminated on the first wiring line group 32 via the insulating film 31 and obtained by dividing another metal film, and vias (contacts) 34. The insulating film 31 is not limited to this, but is a silicon oxide (SiO₂) film, for example. More specifically, the first wiring layer 30 includes only the first wiring line group 32 and the second wiring line group 33 as wiring line groups.

### (First Wiring Line Group and Second Wiring Line Group)

As illustrated in Fig. 4B, the first wiring line group 32 is the wiring line group located closest to the first semiconductor layer 20 among the wiring line groups provided in the first wiring layer 30. In the present embodiment, only the first wiring line group 32 and the second wiring line group 33 are provided as wiring lines (wiring line groups) in the first wiring layer 30, and therefore, the first wiring line group 32 is the wiring line group located closer to the first semiconductor layer 20 than the second wiring line group 33. The first wiring line group 32 includes a plurality of wiring lines provided at intervals in the horizontal direction. More specifically, the first wiring line group 32 includes first pads 32F, reference potential lines 32G, and gate control lines 32T. Among the wiring lines included in the first wiring layer 30, the first pads 32F, the reference potential lines 32G, and the gate control lines 32T are provided closest to the first semiconductor layer 20, and accordingly, the number of wiring line groups included in the first wiring layer 30 can be reduced. More specifically, since any other wiring line group is not provided between the first wiring line group 32 and the first wiring layer 30, the number of wiring line groups included in the first wiring layer 30 can be reduced. As a result, the first wiring layer 30 can be prevented from becoming thicker. As illustrated in Fig. 4C, the reference potential lines 32G and the gate control lines 32T extend in the same direction (row direction). More specifically, the reference potential lines 32G and the gate control lines 32T extend over a plurality of pixel sets 9 arranged in the row direction. On the other hand, one first pad 32F is provided for each pixel set 9 (set 21), and is provided in the gap between two gate control lines 32T in a planar view.

As illustrated in Fig. 4B, the second wiring line group 33 is the wiring line group located closest to the second wiring layer 40 among the wiring line groups provided in the first wiring layer 30, and faces the surface of the first wiring layer 30 on the side of the second wiring layer 40. The second wiring line group 33 includes a plurality of wiring lines provided at intervals in the horizontal direction. More specifically, as illustrated in Fig. 4B, the second wiring line group 33 includes second pads 33F and fourth pads 33G. The second pads 33F and the fourth pads 33G face the surface of the first wiring layer 30 on the side of the second wiring layer 40. The surfaces of the second pads 33F and the fourth pads 33G facing the surface of the first wiring layer 30 on the side of the second wiring layer 40 are referred to as the bonding faces.

The wiring lines of the first wiring line group 32, the second wiring line group 33, and the like are formed with a conductor such as a metal. Examples of the material forming these wiring lines include, but are not limited to, copper, aluminum, and the like.

### (Vias)

The vias 34 connect the wiring lines provided in the first wiring layer 30 to one another, or connect the wiring lines provided in the first wiring layer 30 to the first semiconductor layer 20. There are cases where, among the vias 34, the vias each having one end connected to a charge accumulation region FD and the other end connected to a first pad 32F are referred to as the first vias 34a to be distinguished from the other vias. Also, there are cases where, among the vias 34, the vias each having one end connected to the first semiconductor layer 20 (more specifically, a cell region 20a) and the other end connected to a reference potential line 32G are referred to as the second vias 34b to be distinguished from the other vias. Further, there are cases where, among the vias 34, the vias each having one end connected to the gate electrode G of a transistor T1 and the other end connected to a gate control line 32T are referred to as the third vias 34c to be distinguished from the other vias. In a case where the first vias 34a, the second vias 34b, and the third vias 34c are not distinguished from one another, they are simply referred to as the vias 34. The material forming the vias 34 is not limited to this, but examples thereof include tungsten (W), ruthenium (Ru), copper (Cu), and the like. In the description below, the first pads 32F, the reference potential lines 32G, the gate control lines 32T, the second pads 33F, and the fourth pads 33G will be described in greater detail.

### (First Pads)

Fig. 4C is a diagram illustrating a positional relationship among the pixel sets 9, the first pads 32F, the reference potential lines 32G, and the gate control line 32T in a planar view. As illustrated in Figs. 4C and 4F, each first pad 32F has a rectangular shape, or more specifically, a square shape. Meanwhile, one first pad 32F is provided for each pixel set 9. That is, one first pad 32F is provided for each set 21. Each first pad 32F is provided at a position overlapping the center of a pixel set 9 (set 21) in a planar view. More specifically, each first pad 32F is provided at a position overlapping the center of a pixel set 9 (set 21) in a planar view, in both the X direction and the Y direction. Each first pad 32F is provided at such a position to connect the first pad 32F to all the charge accumulation regions FD in one pixel set 9 (set 21) via the first vias 34a. More specifically, this is because the first pad 32F is connected, via the first vias 34a, to the four charge accumulation regions FD provided at positions close to the center of the pixel set 9 in a planar view. Therefore, the first pad 32F is provided at a position overlapping the charge accumulation regions FD (four charge accumulation regions FD) in a planar view. Here, "overlapping" means that the first pad 32F at least partially overlaps each of the four charge accumulation regions FD. Thus, the first pad 32F and the charge accumulation regions FD can be connected by the first vias 34a.

Although the charge accumulation regions FD are not shown in Fig. 4F, the four first vias 34a connecting the first pad 32F and the charge accumulation regions FD are shown therein. Since the first pad 32F is provided at a position overlapping the four first vias 34a, it can be seen that the first pad 32F is provided at a position overlapping the four charge accumulation regions FD in a planar view. This also applies in drawings similar to Fig. 4F.

Since the first pad 32F is provided at such a position, the first pad 32F can overlap, in the thickness direction, the four charge accumulation regions FD provided at a position near the center of the pixel set 9 in a planar view. Also, since the first pad 32F is provided in the gap between two gate control lines 32T in a planar view, the first pad 32F can be provided at a position overlapping the charge accumulation regions FD in a planar view without intersecting the extending direction (X direction) of the reference potential lines 32G and the gate control lines 32T. Accordingly, the first pad 32F, the reference potential lines 32G, and the gate control lines 32T can be provided as the first wiring line group 32 obtained by dividing one metal film. Thus, an increase in the number of wiring line groups in the thickness direction of the first wiring layer 30 can be prevented, and an increase in the thickness of the first wiring layer 30 can be prevented. Also, as one first pad 32F is provided so as to overlap the center of a pixel set 9 (set 21) in a planar view, it is possible to prevent an increase in the horizontal wiring routing distance between the charge accumulation regions FD and the first pad 32F.

The first pad 32F is connected to the charge accumulation regions FD via the first vias 34a. In a case where a plurality (four in the present embodiment) of charge accumulation regions FD is provided for each pixel set 9 (set 21), the first pad 32F and each charge accumulation region FD are connected via a different first via 34a. Note that the first pads 32F in Fig. 4C are denoted by the letter "F" to clearly indicate that the first pads 32F are electrically connected to the charge accumulation regions FD. In the drawings that follow, the pads electrically connected to the charge accumulation regions FD are denoted by the letter "F" in some cases.

### (Reference Potential Lines)

The reference potential lines 32G are provided for the respective rows of the pixel sets 9. More specifically, two reference potential lines 32G are provided for each row of the pixel sets 9. These two reference potential lines 32G are referred to as reference potential lines 32G1 and 32G2 to distinguish them from each other. In a case where the reference potential lines 32G1 and 32G2 are not distinguished from each other, they are simply referred to as the reference potential lines 32G. The reference potential VSS is designed to be applied to the reference potential lines 32G. The reference potential VSS is then applied also to the semiconductor regions, the vias, and the wiring lines electrically connected to the reference potential lines 32G. The reference potential lines 32G are connected to the first semiconductor layer 20 via the second vias 34b. More specifically, the reference potential lines 32G are connected to well regions (not shown) of the pixel set 9 via the second vias 34b.

### (Gate Control Lines)

Each gate control line 32T is one of the pixel drive lines 10, and the vertical drive circuit 4 controls the transistors T1 via the gate control lines 32T. The gate control lines 32T are not provided over a plurality of wiring line groups, but belongs only to the first wiring line group 32 among the wiring line groups. Thus, an increase in the number of wiring line groups included in the first wiring layer 30 can be prevented, and an increase in the thickness of the first wiring layer 30 can be prevented. As illustrated in Fig. 4C, the gate control lines 32T are provided for the respective rows of the pixel sets 9. More specifically, four gate control lines 32T are provided for each row of the pixel sets 9. These four gate control lines 32T are referred to as gate control lines 32T1, 32T2, 32T3, and 32T4 to be distinguished from one another. In a case where the gate control lines 32T1, 32T2, 32T3, and 32T4 are not distinguished from one another, they are simply referred to as the gate control lines 32T. The gate control lines 32T1 and 32T2 are located at positions overlapping the cell regions 20a1 and 20a2 in a planar view. The gate electrodes G included in the cell regions 20a1 and 20a2 overlap both the gate control lines 32T1 and 32T2 in a planar view. One and the other one of the gate control lines 32T1 and 32T2 control the transistors T1 corresponding to one and the other one of the cell regions 20a1 and 20a2. Also, the gate control lines 32T3 and 32T4 are located at positions overlapping the cell regions 20a3 and 20a4 in a planar view. The gate electrodes G included in the cell regions 20a3 and 20a4 overlap both the gate control lines 32T3 and 32T4 in a planar view. One and the other one of the gate control lines 32T3 and 32T4 control the transistors T1 corresponding to one and the other one of the cell regions 20a3 and 20a4. As illustrated in Fig. 4B, the present embodiment is described on the assumption that the gate control line 32T2 controls the transistor T1 corresponding to the cell region 20a1, and the gate control line 32T3 controls the transistor T1 corresponding to the cell region 20a4. The gate control lines 32T are provided at positions overlapping the gate electrodes of the transistors T1 to be controlled in a planar view. Further, the gate control lines 32T are connected, via the third vias 34c, to the gate electrodes of the transistors T1 to be controlled. More specifically, the gate control lines 32T are connected to the gate electrodes of the transistors T1 to be controlled, only through the third vias 34c without through the other wiring lines.

### (Second Pads and Fourth Pads)

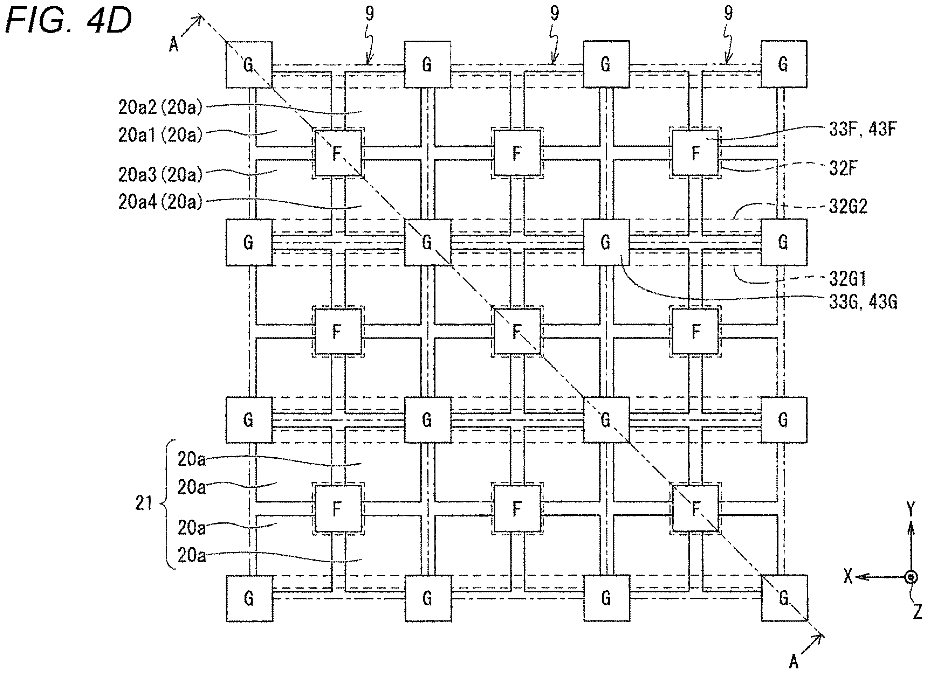

Fig. 4D is a diagram illustrating a positional relationship among the pixel sets 9, the second pads 33F, and the fourth pads 33G in a planar view. As illustrated in Fig. 4D, one second pad 33F is provided for each pixel set 9. That is, one second pad 33F is provided for each set 21. Each second pad 33F is provided at a position overlapping the center of a pixel set 9 (set 21) in a planar view. Also, each second pad 33F is provided at a position overlapping a first pad 32F in a planar view, and is electrically connected to the first pad 32F through a via 34. As one second pad 33F is provided so as to overlap the center of a pixel set 9 (set 21) and a first pad 32F in a planar view, it is possible to prevent an increase in the wiring routing distance from the charge accumulation region FD to the second pad 33F. Each second pad 33F has a rectangular shape. More specifically, each second pad 33F has a square shape. Furthermore, even in a case where a plurality (four in the present embodiment) of charge accumulation regions FD is provided for each pixel set 9 (set 21), all signals from the respective charge accumulation regions FD of the plurality of charge accumulation regions FD flow into one first pad 32F. Therefore, there is no need to provide a second pad 33F for each charge accumulation region FD, and one second pad 33F is only required to be provided for each pixel set 9 (set 21). Accordingly, more space can be saved than in a case where a plurality of second pads 33F is provided for each pixel set 9 (set 21). Thus, an increase in difficulty of miniaturization of the pixels 3 can be prevented.

The fourth pads 33G are disposed at positions overlapping the corner portions of the pixel sets 9 (sets 21) in a planar view. Each fourth pad 33G is provided at a position overlapping an intersection of four pixel sets 9 (four sets 21) arranged in two rows and two columns in a planar view. More specifically, each fourth pad 33G is provided at a position overlapping the corner portions adjacent to one another of four sets 21 arranged in two rows and two columns. Further, each fourth pad 33G is provided in a direction at an angle of 45 degrees from the second pads 33F in a planar view. When a case where each fourth pad 33G is provided in a direction at an angle of 45 degrees from the second pads 33F is compared with a case where the fourth pads 33G are aligned with the second pads 33F in the row direction and the column direction, the distance between a fourth pad 33G and a second pad 33F can be made 2^{0.5} times (twice the root) wider in the case where each fourth pad 33G is provided in a direction at an angle of 45 degrees, because the fourth pads 33G and the second pads 33F are arranged in directions orthogonal to the pixels 3. Further, one fourth pad 33G is connected to both of the two reference potential lines 32G1 and 32G2 via the second vias 34b. Accordingly, more space can be saved than in a case where one fourth pad 33G is provided for each of the two reference potential lines 32G1 and 32G2. Thus, an increase in difficulty of the manufacturing process can be prevented.

Further, each fourth pad 33G is provided at a position overlapping a reference potential line 32G in a planar view, and is electrically connected to the reference potential line 32G via a via 34. More specifically, each fourth pad 33G is electrically connected to the adjacent reference potential lines 32G1 and 32G2. Also, the fourth pads 33G are electrically connected to the reference potential lines 32G. Accordingly, the reference potential is applied to the fourth pads 33G, and thus, interference due to coupling can be prevented from occurring between the second pads 33F.

Each fourth pad 33G has a rectangular shape. More specifically, each fourth pad 33G has a square shape. The fourth pads 33G have the same dimension (size) as the second pads 33F. Further, the arrangement pitch of the fourth pads 33G in the row direction and the column direction are the same as the arrangement pitch of the second pads 33F in the row direction and the column direction. Accordingly, the second pads 33F and the fourth pads 33G are arranged with the same size and in the same cycles, and thus, an increase in difficulty of the process of manufacturing the second pads 33F and the fourth pads 33G can be prevented. Note that the fourth pads 33G in Fig. 4D are denoted by the letter "G" to clearly indicate that the fourth pads 33G are electrically connected to the reference potential lines 32G. In the drawings that follow, the pads electrically connected to the reference potential lines 32G are denoted by the letter "G" in some cases.

### <Second Wiring Layer>

As illustrated in Fig. 4B, the second wiring layer 40 includes an insulating film 41, wiring lines 42, third pads 43F, fifth pads 43G, and vias (contacts) 44. The wiring lines stacked in the thickness direction of the second wiring layer 40, the wiring lines 42, the third pads 43F, and the fifth pads 43G are stacked via the insulating film 41, for example. The third pads 43F and the fifth pads 43G face the surface of the second wiring layer 40 on the side of the first wiring layer 30. The surfaces of the third pads 43F and the fifth pads 43G facing the surface of the second wiring layer 40 on the side of the first wiring layer 30 are referred to as the bonding faces. The vias 44 connect the wiring lines 42 to one another, the wiring lines 42 to the third pads 43F, the wiring lines 42 to the fifth pads 43G, and the like.

Further, as illustrated in Fig. 4D, the third pads 43F are provided at positions overlapping the second pads 33F in a planar view, and the bonding faces of the third pads 43F are bonded to the bonding faces of the second pads 33F. With this arrangement, the charge accumulation regions FD to the third pads 43F of the second wiring layer 40 are electrically connected in the thickness direction (the stacking direction or the Z direction). More specifically, the paths from the charge accumulation regions FD to the third pads 43F are routed in the thickness direction, without the wiring lines being routed in the horizontal direction.

Also, the fifth pads 43G are provided at positions overlapping the fourth pads 33G in a planar view, and the bonding faces of the fifth pads 43G are bonded to the bonding faces of the fourth pads 33G. With this arrangement, the first semiconductor layer 20 to the fifth pads 43G of the second wiring layer 40 are electrically connected in the thickness direction (the stacking direction or the Z direction). More specifically, the reference potential paths from the first semiconductor layer 20 to the fifth pads 43G are routed in the thickness direction, without the wiring lines being routed in the horizontal direction.

The third pads 43F and the fifth pads 43G each have a rectangular shape. More specifically, the third pads 43F and the fifth pads 43G each have a square shape. The third pads 43F have the same dimension (size) as the fifth pads 43G. Further, the arrangement pitch of the third pads 43F in the row direction and the column direction are the same as the arrangement pitch of the fifth pads 43G in the row direction and the column direction. Accordingly, the third pads 43F and the fifth pads 43G are arranged with the same size and in the same cycles, and thus, an increase in difficulty of the process of manufacturing the third pads 43F and the fifth pads 43G can be prevented. Further, the dimension of the third pads 43F and the fifth pads 43G, and the arrangement pitch thereof in the row direction and the column direction are the same as those of the second pads 33F and the fourth pads 33G.

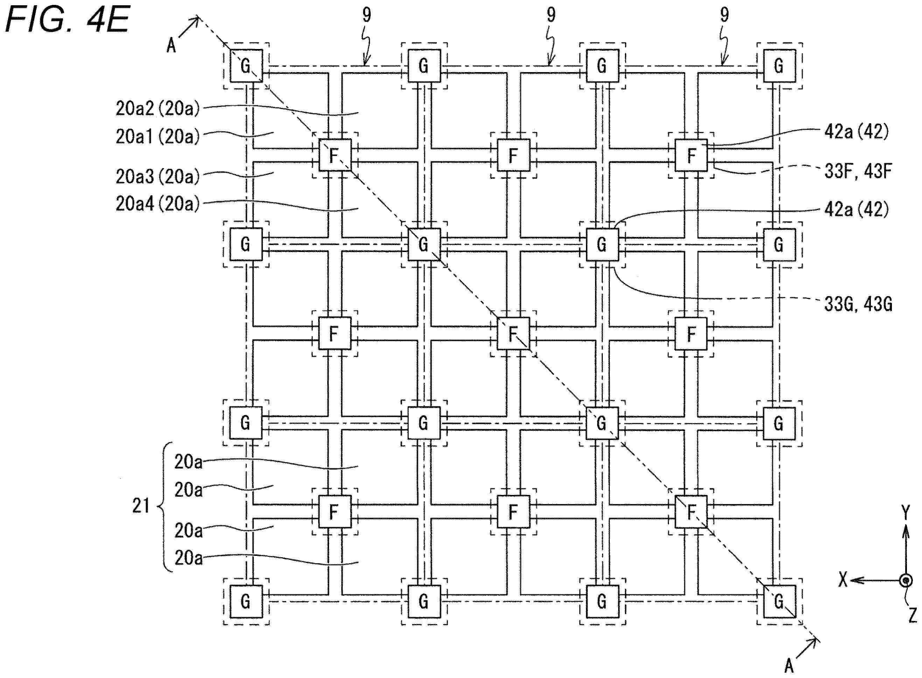

Furthermore, Fig. 4E illustrates the wiring lines 42 disposed one layer closer to the second semiconductor layer 50 than the third pads 43F and the fifth pads 43G. These wiring lines 42 are referred to as wiring lines 42a to be distinguished from the other wiring lines, but are simply referred to as the wiring lines 42 in a case where they are not distinguished from the other wiring lines. As illustrated in Fig. 4E, the wiring lines 42a are provided at positions overlapping the third pads 43F in a planar view, and at positions overlapping the fifth pads 43G in a planar view. The wiring lines 42a and the third pads 43F, and the wiring lines 42a and the fifth pads 43G are connected via the vias 44.

The wiring lines such as the wiring lines 42, the third pads 43F, and the fifth pads 43G are formed with a conductor such as a metal. Examples of the material forming these wiring lines include, but are not limited to, copper, aluminum, and the like. Also, examples of the metal forming the second wiring line group 33 include, but are not limited to, copper, aluminum, and the like. Further, the material forming the vias 44 is not limited to this, but examples thereof include tungsten (W), ruthenium (Ru), copper (Cu), and the like. The insulating film 41 is not limited to this, but is a silicon oxide (SiO₂) film, for example.

### <Second Semiconductor Layer>

As illustrated in Fig. 4B, the second semiconductor layer 50 includes a semiconductor substrate. The second semiconductor layer 50 is not limited to this, and is formed with a single-crystal silicon substrate, for example. A plurality of transistors is provided in the second semiconductor layer 50. Among the transistors, transistors T2 provided in a region overlapping the pixel region 2A in a planar view in the second semiconductor layer 50 are transistors constituting the readout circuit 15 illustrated in Fig. 3, for example. Among the transistors T2, a transistor having its gate electrode G electrically connected to a charge accumulation region FD is the amplification transistor AMP illustrated in Fig. 3. As illustrated in Fig. 4B, each transistor T2 that is an amplification transistor AMP is referred to as a transistor T2A to be distinguished from the other transistors T2. In a case where the transistors T2A and the other transistors T2 are not distinguished from each other, they are simply referred to as the transistors T2. Further, the transistors T2 are transistors of the same type as the transistors T1 provided in the first semiconductor layer 20.

The gate electrodes G of the transistors T2A are electrically connected to the third pads 43F. More specifically, the gate electrodes G of the transistors T2A are electrically connected to the charge accumulation regions FD through the vias 44, the third pads 43F, the second pads 33F, the first pads 32F, the vias 34, and the like. With this arrangement, the charge accumulation regions FD to the gate electrodes G of the transistors T2A are electrically connected in the thickness direction (the stacking direction or the Z direction). More specifically, the paths from the charge accumulation regions FD to the gate electrodes G of the transistors T2A are routed in the thickness direction, without the wiring lines being routed in the horizontal direction. Furthermore, the gate electrodes G of the transistors T2A are not limited to this, but may be located at positions overlapping the first pads 32F in a planar view, for example. The transistors T2A can output a voltage corresponding to a voltage to be input to the gate electrodes G. That is, the transistors T2A form a source follower circuit.

Also, a plurality of through electrodes penetrating the second semiconductor layer 50 in the thickness direction is provided in the second semiconductor layer 50. Fig. 4A shows through electrodes TSV provided in the peripheral region 2B among such through electrodes. In the present embodiment, the semiconductor layers are formed with silicon, and accordingly, the through electrodes TSV are through-silicon vias. Note that the through electrodes may be disposed at portions of the second semiconductor layer 50 overlapping the pixel region 2A. The through electrodes TSV are not limited to this, but are formed with a metal such as copper or tungsten, for example.

### <Third Wiring Layer>

As illustrated in Fig. 4A, the third wiring layer 60 includes an insulating film 61 and sixth pads 62. The sixth pads 62 face the surface of the third wiring layer 60 on the side of the fourth wiring layer 70. The surfaces of the sixth pads 62 facing the surface of the third wiring layer 60 on the side of the fourth wiring layer 70 are referred to as the bonding faces. The sixth pads 62 are formed with a conductor such as metal. Examples of the material forming the sixth pads 62 include, but are not limited to, copper, aluminum, and the like. The insulating film 61 is not limited to this, but is a silicon oxide (SiO₂) film, for example.

### <Fourth Wiring Layer>

As illustrated in Fig. 4A, the fourth wiring layer 70 includes an insulating film 71, wiring lines 72, seventh pads 73, and vias (contacts) 74. The wiring lines 72 and the seventh pads 73 are stacked, with the insulating film 71 being interposed in between, as illustrated in the drawing. The seventh pads 73 face the surface of the fourth wiring layer 70 on the side of the third wiring layer 60. The surfaces of the seventh pads 73 facing the surface of the fourth wiring layer 70 on the side of the third wiring layer 60 are referred to as the bonding faces. The bonding faces of the seventh pads 73 are bonded to the bonding faces of the sixth pads 62. The vias 74 connect the third semiconductor layer 80 to the wiring lines 72, the wiring lines 72 to one another, the wiring lines 72 to the seventh pads 73, and the like. Further, wiring lines such as the wiring lines 72 and the seventh pads 73 are formed with a conductor such as a metal. Examples of the material forming these wiring lines include, but are not limited to, copper, aluminum, and the like. Further, the material forming the vias 74 is not limited to this, but examples thereof include tungsten (W), ruthenium (Ru), copper (Cu), and the like. The insulating film 71 is not limited to this, but is a silicon oxide (SiO₂) film, for example.

### <Third Semiconductor Layer>

The third semiconductor layer 80 includes a semiconductor substrate. The third semiconductor layer 80 is not limited to this, and is formed with a single-crystal silicon substrate, for example. A plurality of transistors T3 is provided in the third semiconductor layer 80. The transistors T3 are not limited to this, but are transistors constituting the logic circuit 13 illustrated in Fig. 2, for example.

### <<Method for Manufacturing the Photodetection Device>>

In the description below, a method for manufacturing the photodetection device 1 is described with reference to Fig. 5. First, in step S10, the first semiconductor layer 20, the second semiconductor layer 50, and the third semiconductor layer 80 are prepared. More specifically, elements such as the transistors, the photoelectric conversion elements, and the charge accumulation regions FD, or diffusion regions are formed in these semiconductor layers as necessary, for example, but the configuration is not limited to this. Further, the first wiring layer 30 is stacked on the first semiconductor layer 20, the second wiring layer 40 is stacked on the second semiconductor layer 50, and the fourth wiring layer 70 is stacked on the third semiconductor layer 80.

In step S20, the first wiring layer 30 and the second wiring layer 40 are then bonded to each other, so that the side of the first semiconductor layer 20 and the side of the second semiconductor layer 50 are bonded to each other. Furthermore, by this bonding, the second pads 33F are bonded to the third pads 43F, and the fourth pads 33G are bonded to the fifth pads 43G.

Next, in step S30, the second semiconductor layer 50 is ground and thinned by a known technique such as back grinding. More specifically, the surface of the second semiconductor layer 50 on the opposite side from the side of the second wiring layer 40 is ground and thinned.

After that, in step S40, the third wiring layer 60 is stacked on the ground surface of the second semiconductor layer 50, and through electrodes penetrating in the thickness direction are formed. More specifically, through electrodes including the through electrodes TSV are formed.

Next, in step S50, the third wiring layer 60 and the fourth wiring layer 70 are bonded to each other, so that the side of the second semiconductor layer 50 and the side of the third semiconductor layer 80 are bonded to each other. Also, the sixth pads 62 are bonded to the seventh pads 73 by this bonding.

Further, in step S60, the first semiconductor layer 20 is ground and thinned by a known technique such as back grinding. More specifically, the surface of the first semiconductor layer 20 on the opposite side from the side of the first wiring layer 30 is ground and thinned. After that, the separation region 20b is formed, and the processing of the back surface side (the side of the second surface S2) of the first semiconductor layer 20 is performed, to form the planarization film FL, the color filters CF, the microlenses ML, and the like. In this manner, the photodetection device 1 is almost completed. The photodetection device 1 is formed in each region of a plurality of chip formation regions defined by scribe lines (dicing lines) on a semiconductor substrate. The plurality of chip formation regions is then divided into single chips along the scribe lines. Thus, the semiconductor chip 2 on which the photodetection device 1 is mounted is formed.

### <<Principal Effects of the First Embodiment>>

In the description below, the principal effects of the first embodiment are explained, but a conventional example is explained before that. Conventionally, a photodetection device 1 in which one readout circuit 15 is shared by a plurality of pixels 3 has wiring lines that are provided between a first semiconductor layer 20 and a first wiring line group 32 in the thickness direction of a first wiring layer 30, and are routed in the horizontal direction. Here, these wiring lines are referred to as wiring lines L. Although the wiring lines L are not limited to this, there have been cases where the wiring lines L are used as wiring lines connecting one charge accumulation region FD and the other charge accumulation regions FD in the same pixel set 9, for example. Further, in a case where the wiring lines L are routed in a direction intersecting with the direction in which reference potential lines 32G and gate control lines 32T are routed, it is necessary to route the wiring lines L to intersect with the reference potential lines 32G and the gate control lines 32T while electrically insulating the wiring lines L from the reference potential lines 32G and the gate control lines 32T. Therefore, in the thickness direction of the first wiring layer 30, the wiring lines L, the reference potential lines 32G, and the gate control lines 32T cannot be provided as wiring lines of the same layer. That is, the wiring lines L need to be provided as one wiring line group, and the reference potential lines 32G and the gate control lines 32T need to be provided as another wiring line group, with the insulating film 31 being interposed in between.

Also, in a case where the photodetection device 1 is of a stacked type in which a plurality of semiconductor layers is stacked, the charge accumulation regions FD and the amplification transistors AMP are disposed in different semiconductor layers. Therefore, the distance between the charge accumulation regions FD and the amplification transistors AMP is longer than that in a case with a non-stacked type. Further, as the distance becomes longer, the capacitance Cfd of the charge accumulation region FD illustrated in Fig. 3 becomes greater. As the capacitance Cfd increases, the amplitude of the voltage value V to be supplied from the charge accumulation region FD to the readout circuit 15 becomes smaller, as already described. More specifically, the amplification transistor AMP transmits a potential difference between a case where the charge accumulation region FD accumulates signal charges and a case where the charge accumulation region FD does not accumulate signal charges, to the subsequent stage with a source follower. Therefore, when the amplitude of the voltage value V becomes smaller, the conversion efficiency attributable to the capacitance of the charge accumulation region FD drops.

Further, when the wiring lines L described above are provided in the photodetection device 1 of a stacked type in which a plurality of semiconductor layers is stacked, the distance between the charge accumulation region FD and the amplification transistor AMP becomes even longer. Therefore, the capacitance Cfd of the charge accumulation region FD becomes larger, and there is a possibility that the amplitude of the voltage value V will be smaller. Because of this, there is a possibility that the conversion efficiency will become even lower.

In the photodetection device 1 according to the first embodiment of the present technology, on the other hand, the first wiring line group 32 is the wiring line group located closest to the first semiconductor layer 20, and any of the conventional wiring lines L is not disposed between the first wiring line group 32 and the first semiconductor layer 20. With this arrangement, the number of wiring line groups provided in the first wiring layer 30 can be reduced. Accordingly, an increase in the thickness of the first wiring layer 30 can be prevented, and an increase in the distance between the charge accumulation regions FD and the amplification transistors AMP can be prevented. An increase in the capacitance Cfd of the charge accumulation regions FD can be prevented, and a decrease in the amplitude of the voltage value V can be prevented. Thus, a decrease in conversion efficiency can be prevented.

Also, in the photodetection device 1 according to the first embodiment of the present technology, the first pads 32F are disposed at positions overlapping the charge accumulation regions FD in a planar view, without intersecting the extending direction (X direction) of the reference potential lines 32G and the gate control lines 32T. As wiring lines that do not intersect with one another can be formed by dividing one metal film, the first pads 32F, the reference potential lines 32G, and the gate control lines 32T can be provided as the first wiring line group 32 that is a wiring line group obtained by dividing one metal film. Because of this, an increase in the number of wiring line groups in the first wiring layer 30 can be prevented, an increase in the thickness of the first wiring layer 30 can be prevented, and an increase in the distance between the charge accumulation regions FD and the amplification transistors AMP can be prevented. Accordingly, an increase in the capacitance Cfd of the charge accumulation regions FD can be prevented, and a decrease in the amplitude of the voltage value V can be prevented. Thus, a decrease in conversion efficiency can be prevented.

Also, in the photodetection device 1 according to the first embodiment of the present technology, the first semiconductor layer 20 includes a plurality of sets 21 including four cell regions 20a arranged in two rows and two columns. The sets 21 are rectangular in a planar view. At least one charge accumulation region FD, one first pad 32F, and one second pad 33F are provided for each set 21, and a first pad 42F is provided at a position overlapping the center of the set 21 in a planar view. Because of this, the first pad 32F can be connected to the four charge accumulation regions FD provided at positions near the center of the pixel set 9 in a planar view via the first vias 34a, and it is possible to prevent an increase in the horizontal wiring routing distance between the charge accumulation regions FD and the first pad 32F. Accordingly, an increase in the distance between the charge accumulation regions FD and the amplification transistors AMP can be prevented, an increase in the capacitance Cfd of the charge accumulation regions FD can be prevented, and a decrease in the amplitude of the voltage value V can be prevented. Thus, a decrease in conversion efficiency can be prevented.

Also, in the photodetection device 1 according to the first embodiment of the present technology, the gate control lines 32T are not provided over a plurality of wiring line groups, but belongs only to the first wiring line group 32 among the wiring line groups. Thus, an increase in the number of wiring line groups included in the first wiring layer 30 can be prevented, and an increase in the thickness of the first wiring layer 30 can be prevented.

Also, in the photodetection device 1 according to the first embodiment of the present technology, even in a case where a plurality (four in the present embodiment) of charge accumulation regions FD is provided for each pixel set 9 (set 21), all signals from the respective charge accumulation regions FD of the plurality of charge accumulation regions FD flow into one first pad 32F. Therefore, there is no need to provide a second pad 33F for each charge accumulation region FD, and one second pad 33F is provided for each pixel set 9 (set 21). Accordingly, more space can be saved than in a case where a plurality of second pads 33F is provided for each pixel set 9 (set 21). Thus, an increase in difficulty of miniaturization of the pixels 3 can be prevented.

Also, in the photodetection device 1 according to the first embodiment of the present technology, the fourth pads 33G have the same dimension (size) as the second pads 33F. Further, the arrangement pitch of the fourth pads 33G in the row direction and the column direction are the same as the arrangement pitch of the second pads 33F in the row direction and the column direction. Accordingly, the second pads 33F and the fourth pads 33G are arranged with the same size and in the same cycles, and thus, an increase in difficulty of the process of manufacturing the second pads 33F and the fourth pads 33G can be prevented. Likewise, the third pads 43F have the same dimension (size) as the fifth pads 43G. Further, the arrangement pitch of the third pads 43F in the row direction and the column direction are the same as the arrangement pitch of the fifth pads 43G in the row direction and the column direction. Accordingly, the third pads 43F and the fifth pads 43G are arranged with the same size and in the same cycles, and thus, an increase in difficulty of the process of manufacturing the third pads 43F and the fifth pads 43G can be prevented.

Note that, in the first embodiment described above, the third surface S3 of the second semiconductor layer 50 is the device formation surface or the principal surface, and the fourth surface S4 of the second semiconductor layer 50 is the back surface, though the present technology is not limited to this. The third surface S3 may be the back surface, and the fourth surface S4 may be the device formation surface or the principal surface. In that case, the elements such as the transistors T2 and the diffusion regions are provided on the side of the fourth surface S4.

### <<Modifications of the First Embodiment>>

In the description below, modifications of the first embodiment are explained.

### <Modification 1>

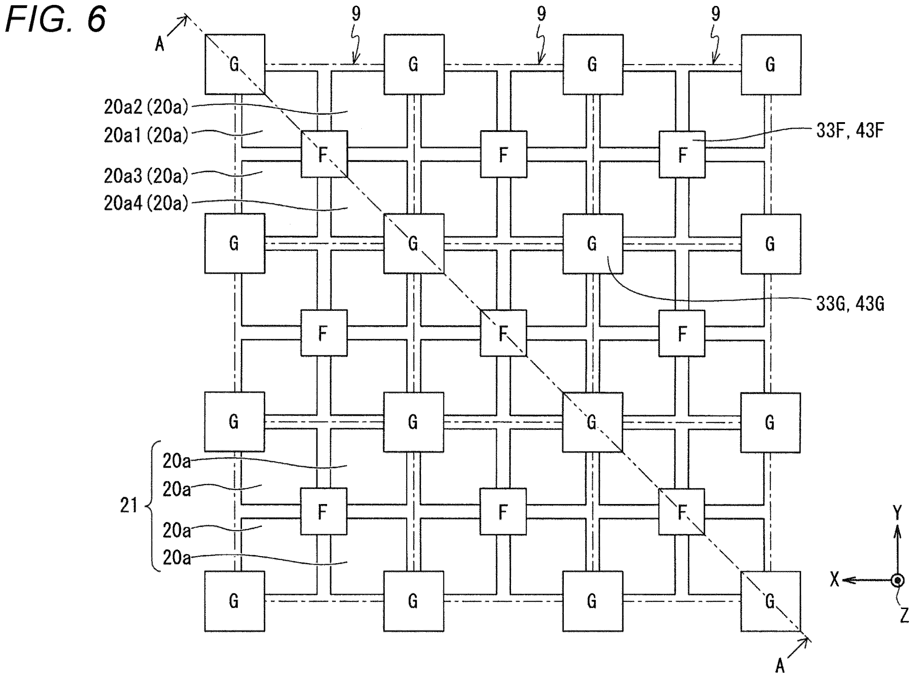

In the photodetection device 1 according to the first embodiment, the second pads 33F and the fourth pads 33G have the same size, and the third pads 43F and the fifth pads 43G have the same size. However, the present technology is not limited to this. In Modification 1 of the first embodiment, as illustrated in Fig. 6, the dimension of the second pads 33F and the dimension of the fourth pads 33G may differ from each other, and the dimension of the third pads 43F and the dimension of the fifth pads 43G may differ from each other. More specifically, the dimension of the fourth pads 33G and the fifth pads 43G is larger than the dimension of the second pads 33F and the third pads 43F.

Effects similar to those of the photodetection device 1 according to the first embodiment described above can be achieved with the photodetection device 1 according to Modification 1 of the first embodiment.

Note that the dimension of the second pads 33F and the third pads 43F may be larger than the dimension of the fourth pads 33G and the fifth pads 43G.

### <Modification 2>

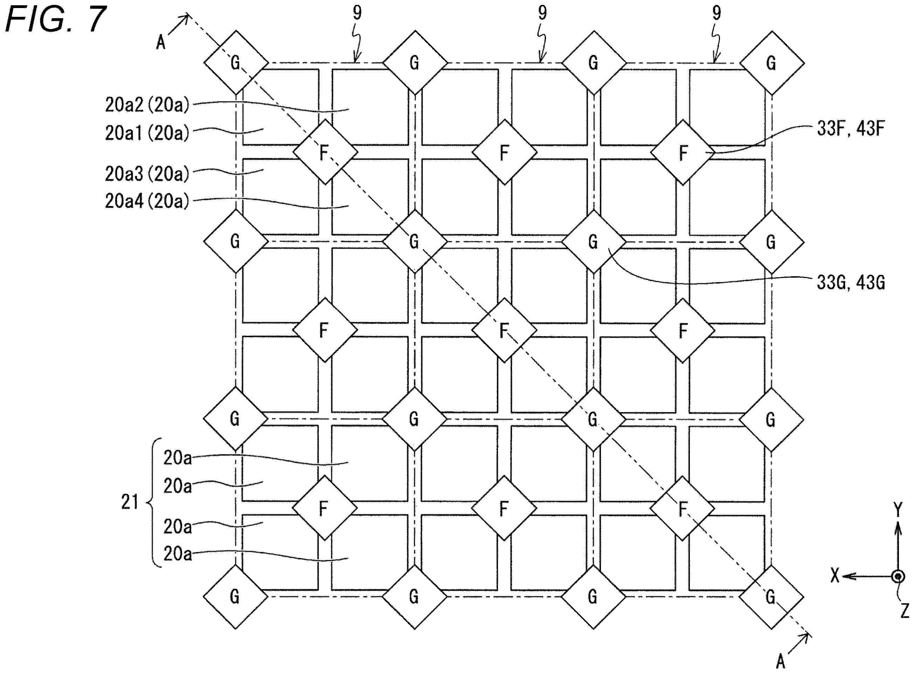

In the photodetection device 1 according to the first embodiment, each side of the second pads 33F, the third pads 43F, the fourth pads 33G, and the fifth pads 43G in a planar view is parallel to the X direction or the Y direction, though the present technology is not limited to this. In Modification 2 of the first embodiment, as illustrated in Fig. 7, the diagonal lines of the second pads 33F, the third pads 43F, the fourth pads 33G, and the fifth pads 43G in a planar view are parallel to the X direction or the Y direction.

As the second pads 33F to the fifth pads 43G are arranged as illustrated in Fig. 7, the shortest distance between the pads is the distance between the sides, but is not the distance between the corners illustrated in Fig. 4D. Because of this, the shortest distance between the pads can be made longer. Further, the shortest distance between the pads is normally managed during the manufacturing process in many cases. As the shortest distance between the pads is set as the distance between the sides, an increase in complexity of length measurement and management can be prevented.

Effects similar to those of the photodetection device 1 according to the first embodiment described above can also be achieved with the photodetection device 1 according to Modification 2 of the first embodiment.

### [Second Embodiment]

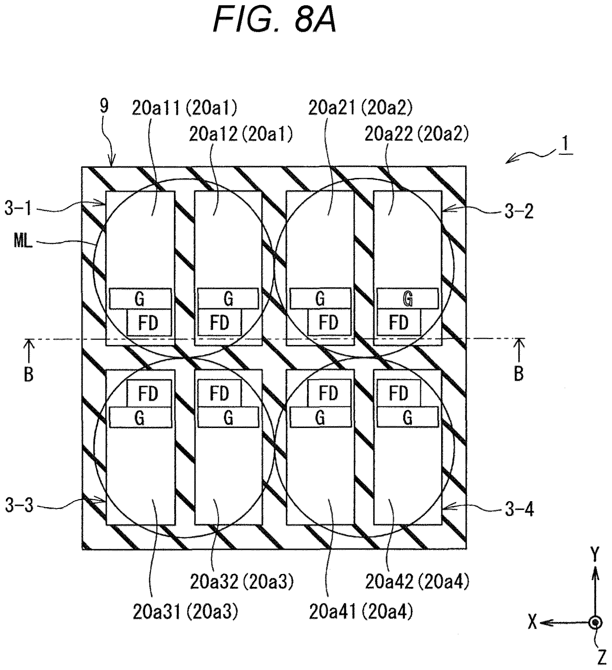

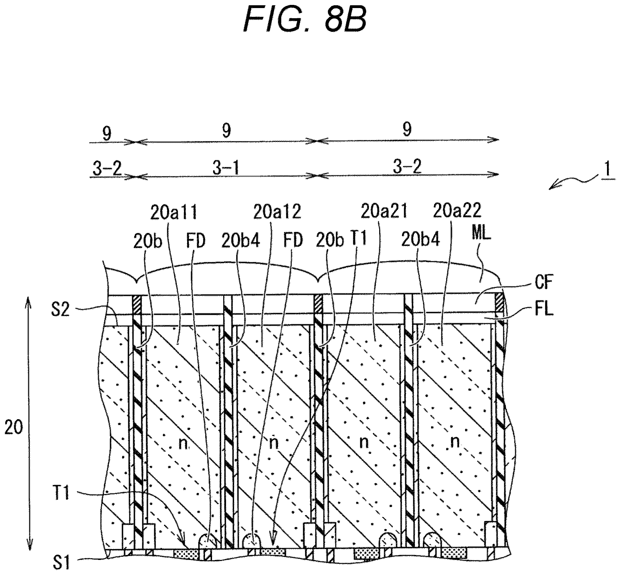

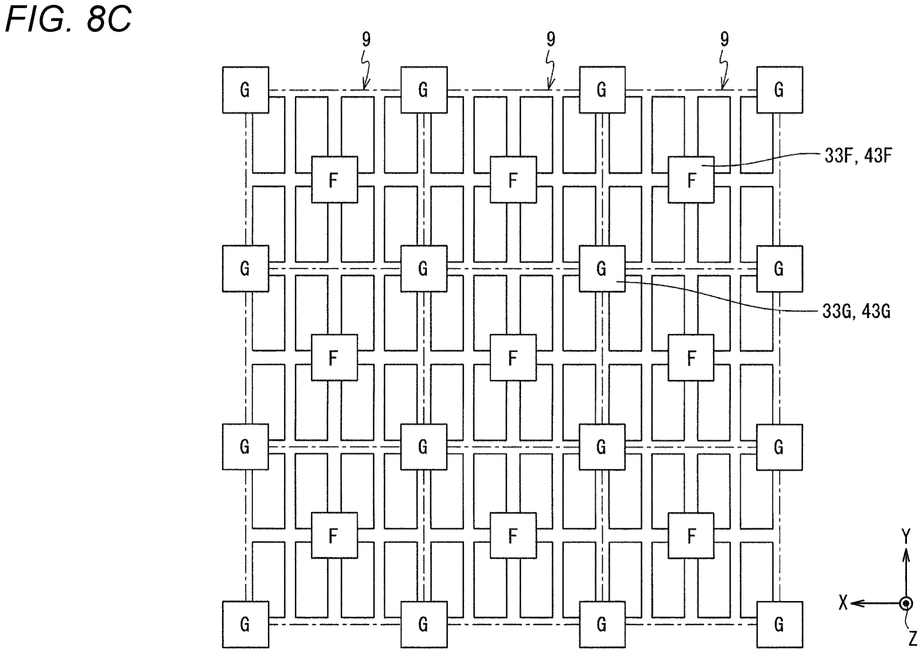

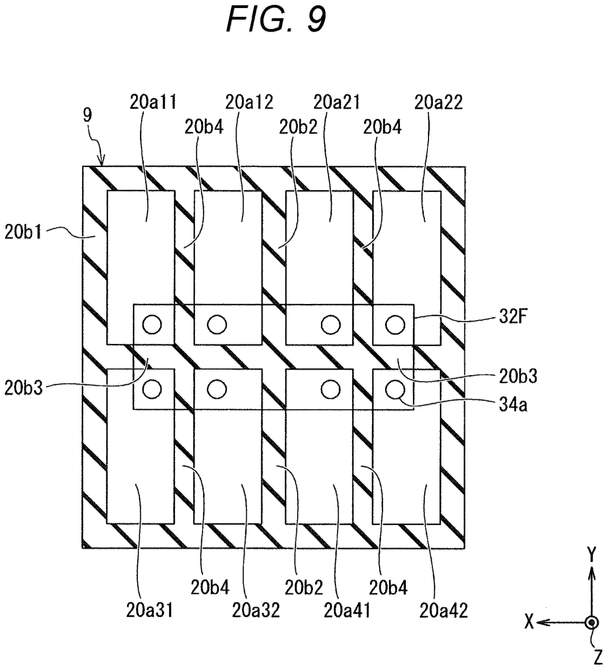

A second embodiment of the present technology illustrated in Figs. 8A, 8B, 8C and 9 is described below. A photodetection device 1 according to the second embodiment differs from the photodetection device 1 according to the first embodiment described above in that the pixels 3 are phase difference detection pixels, and the other aspects of the configuration of the photodetection device 1 are basically similar to those of the photodetection device 1 according to the first embodiment described above. Note that the components already described are denoted by the same reference signs, and explanation of them is not made herein.

### <<Configuration of the Photodetection Device>>

In the description below, the configuration of the photodetection device 1 according to the second embodiment of the present technology is explained, with a focus on portions different from the configuration of the photodetection device 1 according to the first embodiment described above. The pixels 3 are phase difference detection pixels. For example, two photoelectric conversion elements PD are provided in each pixel 3 (each one cell region 20a). Further, a transistor T1 that is a transfer transistor TR is provided for each photoelectric conversion element PD. A microlens ML and a color filter CF are provided for each pixel 3.

The phase difference detection pixels are used for autofocusing. Signal charges photoelectrically converted by the two photoelectric conversion elements PD included in a pixel 3 are read as signals independently of each other, so that phase difference detection is performed. In an in-focus case, there is no difference between the amounts of signal charge accumulated in the two photoelectric conversion elements PD. In an out-of-focus case, on the other hand, there is a difference between the amounts of signal charge accumulated in the two photoelectric conversion elements PD. In an out-of-focus case, the objective lens is operated so that the difference in the signal charge amount becomes smaller. This is autofocusing. Further, the signal charges of the two photoelectric conversion elements PD read out independently of each other are added up, and thus, can be used as a signal of one pixel for an image.

As illustrated in Fig. 8A, one cell region 20a includes two sub-cell regions arranged in the row direction (X direction), for example, and includes one photoelectric conversion element PD for each sub-cell region. The cell region 20a1 includes sub-cell regions 20a11 and 20a12, the cell region 20a2 includes sub-cell regions 20a21 and 20a22, the cell region 20a3 includes sub-cell regions 20a31 and 20a32, and the cell region 20a4 includes sub-cell regions 20a41 and 20a42.

One photoelectric conversion element PD is provided for each sub-cell region. A transistor T1 that is a transfer transistor TR is provided for each photoelectric conversion element PD. Fig. 8A shows the gate electrodes G of the transistors T1 provided for the respective photoelectric conversion elements PD. Also, a charge accumulation region FD is provided for each photoelectric conversion element PD in the example illustrated in Fig. 8A. However, the number of charge accumulation regions FD is not limited to this, and, for example, one charge accumulation region FD may be provided for each four photoelectric conversion elements PD. The eight charge accumulation regions FD included in one pixel set 9 are disposed at positions near the center of the pixel set 9 in the Y direction in a planar view. Further, in the X direction of the pixel set 9 in a planar view, the charge accumulation regions FD are also disposed at positions away from the center of the pixel set 9 in the X direction.

Reference potential lines 32G and gate control lines 32T extend in the same direction (row direction), though these lines are not illustrated in the drawing because they are similar to those in the case of the first embodiment. More specifically, the reference potential lines 32G and the gate control lines 32T extend over a plurality of pixel sets 9 arranged in the row direction. Note that the numbers of the reference potential lines 32G and the gate control lines 32T may be different from those in the case of the first embodiment. For example, the number of the gate control lines 32T may be changed with the number of the transistors T1 corresponding to one pixel 3. One first pad 32F is provided for each pixel set 9 (set 21). As illustrated in Fig. 9, the first pad 32F has a rectangular shape. More specifically, the rectangular shape is elongated in the direction (row direction) in which the reference potential lines 32G and the gate control lines 32T extend.

As described above, in a planar view, the eight charge accumulation regions FD included in one pixel set 9 are provided at positions closer to the center of the pixel set 9 in the column direction (Y direction), but are also provided at positions away from the center of the pixel set 9 in the row direction (X direction). Therefore, to connect to all the charge accumulation regions FD in one pixel set 9 (set 21) via first vias 34a, the first pad 32F overlaps the center of the pixel set 9 (set 21) in the column direction (Y direction) in a planar view, and extends in the row direction so as to cover a large portion of the pixel set 9 in the row direction (X direction). Further, the direction in which first pad 32F extends is the same as the direction (row direction) in which the reference potential lines 32G and the gate control lines 32T extend. Because of this, the first pad 32F can be disposed at a position overlapping the charge accumulation regions FD in a planar view, without intersecting the extending direction (X direction) of the reference potential lines 32G and the gate control lines 32T. Accordingly, the first pad 32F can be provided as the same first wiring line group 32 as the reference potential lines 32G and the gate control lines 32T. Because of this, an increase in the number of wiring line groups in the thickness direction of the first wiring layer 30 can be prevented, and an increase in the thickness of the first wiring layer 30 can be prevented.

As illustrated in Figs. 8A and 9, the first pad 32F is connected to the charge accumulation regions FD via the first vias 34a. In a case where a plurality (eight in the present embodiment) of charge accumulation regions FD is provided for each pixel set 9 (set 21), the first pad 32F and each charge accumulation region FD are connected via a different first via 34a.

As illustrated in Fig. 8C, the configurations of second pads 33F, third pads 43F, fourth pads 33G, and fifth pads 43G are similar to those in the case of the first embodiment, and therefore, detailed explanation thereof is not made herein.

Further, as illustrated in Fig. 9, separation regions 20b include separation regions 20b4 in addition to a separation region 20b1, a separation region 20b2, and a separation region 20b3. Each separation region 20b4 separates the sub-cell regions included in one cell region 20a from each other. More specifically, each separation region 20b4 is a separation region that separates the two sub-cell regions arranged in the row direction of one cell region 20a from each other. Note that, in a case where the separation region 20b1, the separation region 20b2, the separation region 20b3, and the separation regions 20b4 are not distinguished from one another, they are simply referred to as the separation regions 20b. The entire regions from the separation region 20b1 to the separation regions 20b4 are full trench separation regions.

### <<Principal Effects of the Second Embodiment>>

Effects similar to those of the photodetection device 1 according to the first embodiment described above can also be achieved with the photodetection device 1 according to the second embodiment.

Also, in the photodetection device 1 according to the second embodiment, each first pad 32F is elongated in the direction (row direction) in which the reference potential lines 32G and the gate control lines 32T extend. Accordingly, each first pad 32F can be disposed at a position overlapping with all the charge accumulation regions FD in one pixel set in a planar view without intersecting with the extending direction (X direction) of the reference potential lines 32G and the gate control lines 32T, and can be electrically connected to all the charge accumulation regions FD in the one pixel set.

### <<Modifications of the Second Embodiment>>

In the description below, modifications of the second embodiment are explained.

### <Modification 1>

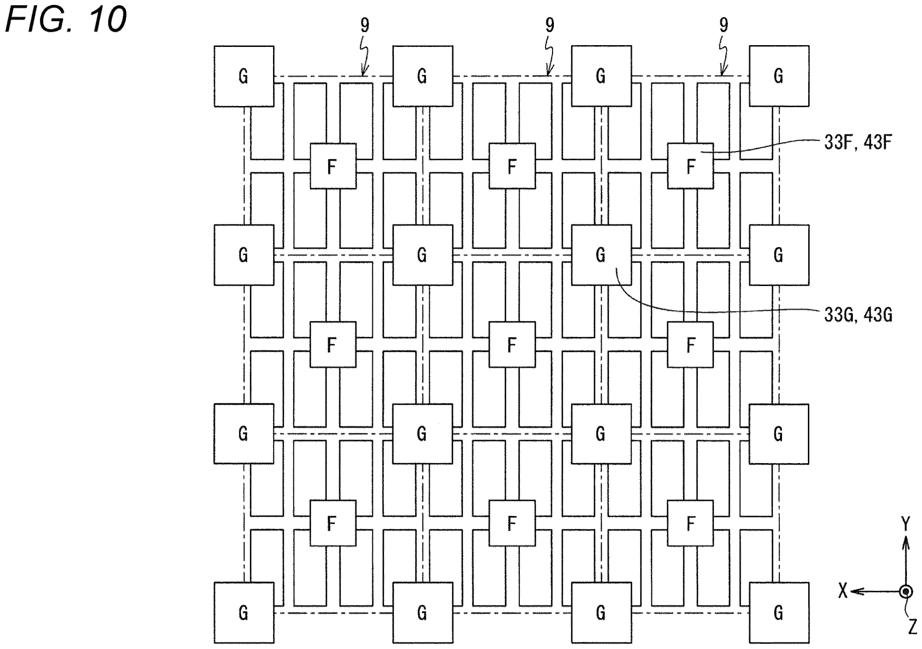

In the photodetection device 1 according to the second embodiment, the second pads 33F and the fourth pads 33G have the same size, and the third pads 43F and the fifth pads 43G have the same size. However, the present technology is not limited to this. In Modification 1 of the second embodiment, as illustrated in Fig. 10, the dimension of the second pads 33F and the dimension of the fourth pads 33G may differ from each other, and the dimension of the third pads 43F and the dimension of the fifth pads 43G may differ from each other. More specifically, the dimension of the fourth pads 33G and the fifth pads 43G is larger than the dimension of the second pads 33F and the third pads 43F.

Effects similar to those of the photodetection device 1 according to the second embodiment described above can also be achieved with the photodetection device 1 according to Modification 1 of the second embodiment.

Note that the dimension of the second pads 33F and the third pads 43F may be larger than the dimension of the fourth pads 33G and the fifth pads 43G.

### <Modification 2>

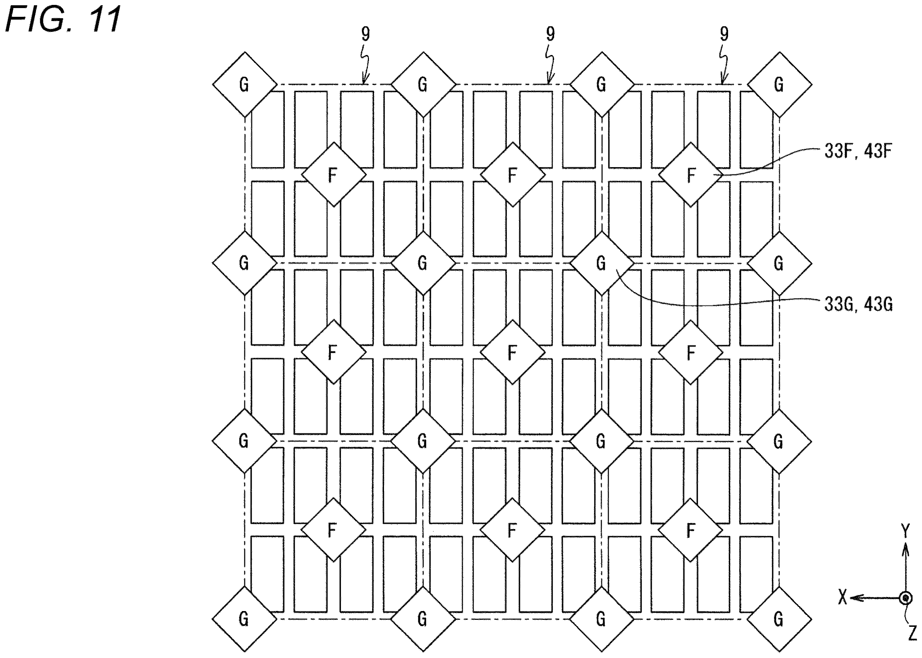

In a photodetection device 1 according to the second embodiment, each side of the second pads 33F, the third pads 43F, the fourth pads 33G, and the fifth pads 43G in a planar view is parallel to the X direction or the Y direction, though the present technology is not limited to this. In Modification 2 of the second embodiment, as illustrated in Fig. 11, the diagonal lines of the second pads 33F, the third pads 43F, the fourth pads 33G, and the fifth pads 43G in a planar view are parallel to the X direction or the Y direction.

As the second pads 33F to the fifth pads 43G are arranged as illustrated in Fig. 11, the shortest distance between the pads is the distance between the sides, but is not the distance between the corners illustrated in Fig. 4D. Because of this, the shortest distance between the pads can be made longer. Further, the shortest distance between the pads is normally managed during the manufacturing process in many cases. As the shortest distance between the pads is set as the distance between the sides, an increase in complexity of length measurement and management can be prevented.

Effects similar to those of the photodetection device 1 according to the second embodiment described above can also be achieved with the photodetection device 1 according to Modification 2 of the second embodiment.

### [Third Embodiment]

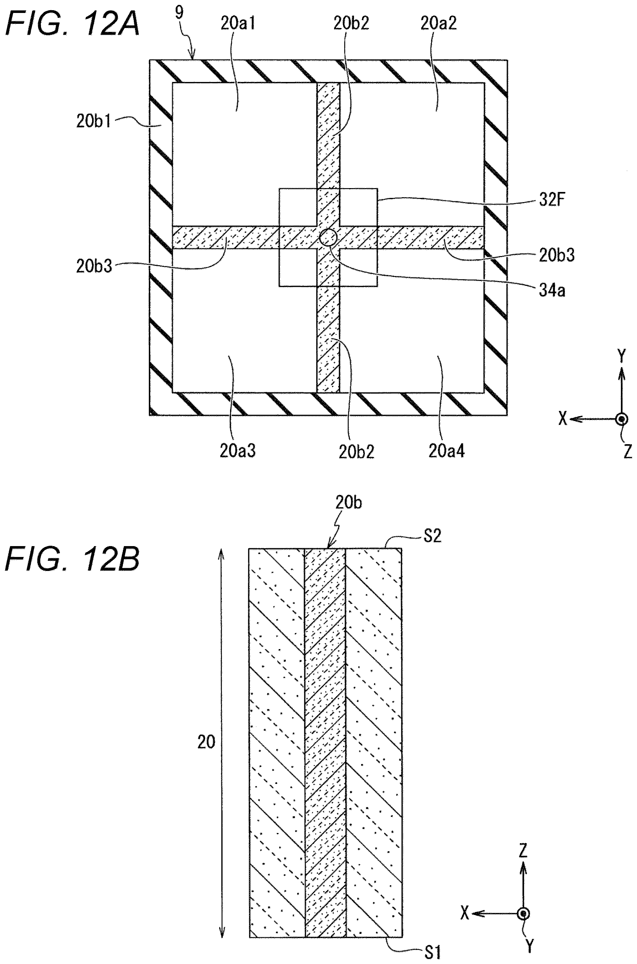

A third embodiment of the present technology illustrated in Figs. 12A and 12B is described below. A photodetection device 1 according to the third embodiment differs from the photodetection device 1 according to the first embodiment described above in the separation regions 20b, and the other aspects of the configuration of the photodetection device 1 are basically similar to those of the photodetection device 1 according to the first embodiment described above. Note that the components already described are denoted by the same reference signs, and explanation of them is not made herein.

In the photodetection device 1 illustrated in Fig. 12A, a separation region 20b1 is a full trench separation region. The full trench separation region has a longitudinal cross-section structure like the separation regions 20b illustrated in Fig. 4A, for example. Note that, in subsequent drawings similar to Fig. 12A, each portion forming a full trench separation region among the separation regions 20b is indicated by the same hatching as that of the separation region 20b1 shown in Fig. 12A.

Separation regions 20b2 and 20b3 are diffusion separation regions that are formed by implanting impurities using a known method such as ion implantation, for example. The diffusion separation regions are semiconductor regions of the first conductivity type (the p-type, for example), though not limited to this. Fig. 12B illustrates an example of a longitudinal sectional view of a diffusion separation region, but the structure of a diffusion separation region is not limited to that shown in Fig. 12B. Note that, in subsequent drawings similar to Fig. 12A, each portion forming a diffusion separation region among the separation regions 20b is indicated by the same hatching as that of the separation regions 20b2 and 20b3 shown in Fig. 12A.

Also, the separation regions 20b2 and 20b3, which are diffusion separation regions, are semiconductor regions, and accordingly, the charge accumulation regions FD can be formed in the separation regions 20b2 and 20b3. In the present embodiment, one charge accumulation region FD is formed in the vicinity of an intersection of the separation region 20b2 and the separation region 20b3. Further, one charge accumulation region FD is shared by the four photoelectric conversion elements and the four transistors T1 in one pixel set 9. Furthermore, one first pad 32F is provided at a position overlapping the one charge accumulation region FD (the center of the pixel set 9) in a planar view, and is connected to the one charge accumulation region FD via one first via 34a.

### <<Principal Effects of the Third Embodiment>>

Effects similar to those of the photodetection device 1 according to the first embodiment described above can also be achieved with the photodetection device 1 according to the third embodiment.

### <<Modifications of the Third Embodiment>>

In the description below, modifications of the third embodiment are explained.

### <Modification 1>

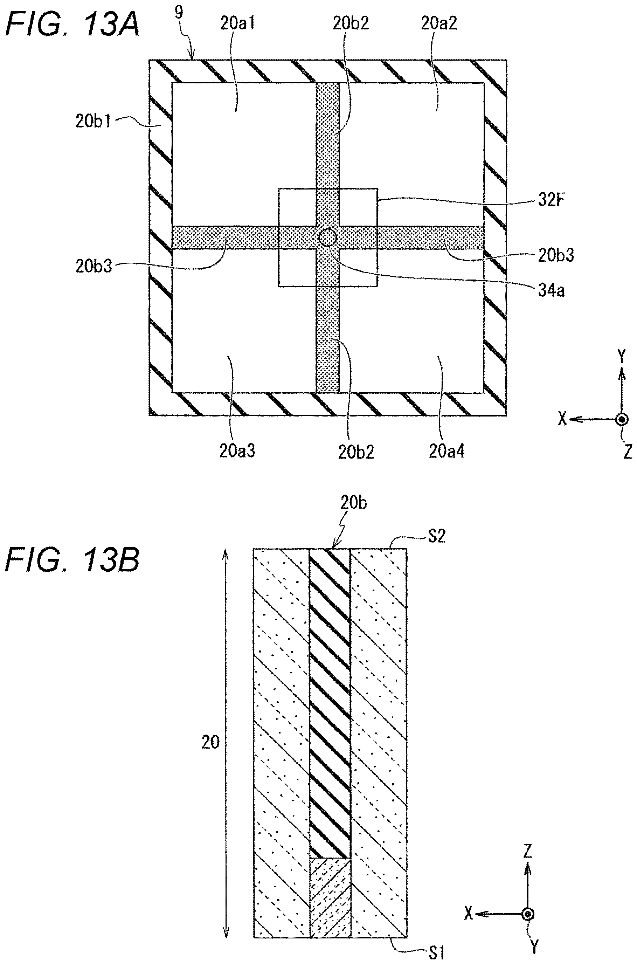

In a photodetection device 1 illustrated in Fig. 13A, the separation region 20b1 is a full trench separation region. The separation regions 20b2 and 20b3 are combinations of a full trench separation region and a diffusion separation region. More specifically, as illustrated in Fig. 13B, in the thickness direction of the first semiconductor layer 20, the portion closer to the second surface S2 is a full trench separation region, and the portion closer to the first surface S1 is a diffusion separation region. Meanwhile, in the separation regions 20b2 and 20b3, the full trench separation regions are larger than the diffusion separation regions in the thickness direction of the first semiconductor layer 20. Note that, in subsequent drawings similar to Fig. 13A, each portion having a structure of a combination of a full trench separation region and a diffusion separation region among the separation regions 20b is indicated by the same hatching as that of the separation regions 20b2 and 20b3 shown in Fig. 13A. Further, such a structure will be hereinafter referred to as a "combination of a full trench separation region and a diffusion separation region".

Meanwhile, in each of the separation regions 20b2 and 20b3, as illustrated in Fig. 13B, the portion close to the first surface S1 is a semiconductor region (diffusion separation region). Accordingly, a charge accumulation region FD can be formed in the separation regions 20b2 and 20b3. In this modification, one charge accumulation region FD is formed in the vicinity of an intersection of the separation region 20b2 and the separation region 20b3. Further, one charge accumulation region FD is shared by the four photoelectric conversion elements and the four transistors T1 in one pixel set 9. Furthermore, one first pad 32F is provided at a position overlapping the one charge accumulation region FD (the center of the pixel set 9) in a planar view, and is connected to the one charge accumulation region FD via one first via 34a.

### <Modification 2>

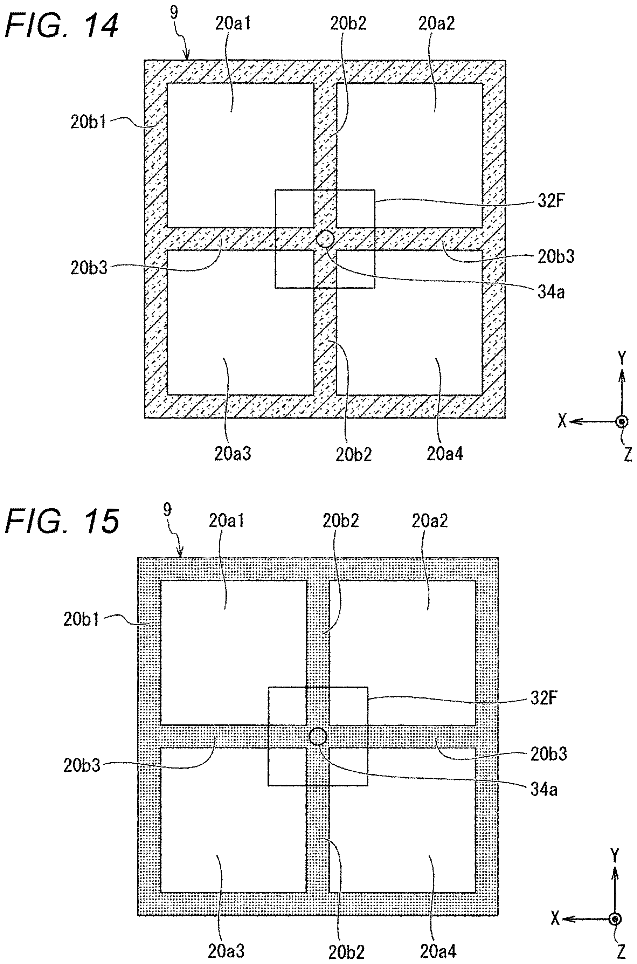

In a photodetection device 1 illustrated in Fig. 14, all the separation regions 20b1, 20b2, and 20b3 are diffusion separation regions.

### <Modification 3>

In a photodetection device 1 illustrated in Fig. 15, all the separation regions 20b1, 20b2, and 20b3 are combinations of a full trench separation region and a diffusion separation region.

### <Modification 4>

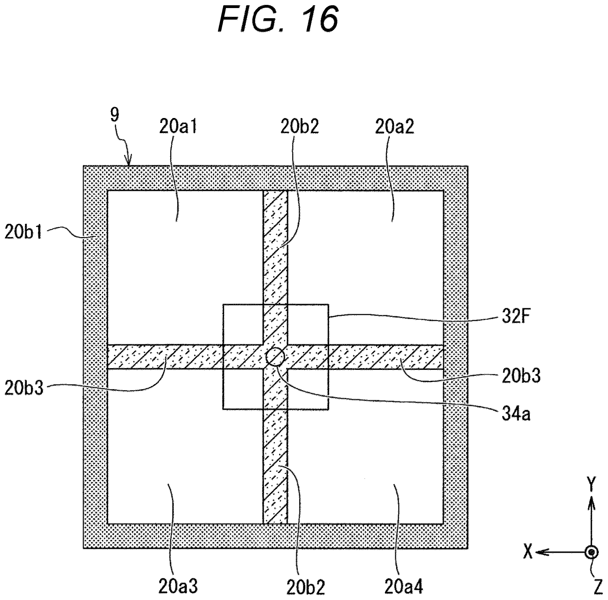

In a photodetection device 1 illustrated in Fig. 16, the separation region 20b1 is a combination of a full trench separation region and a diffusion separation region. The separation regions 20b2 and 20b3 are diffusion separation regions.

### <<Principal Effects of the Modifications of the Third Embodiment>>

Effects similar to those of the photodetection device 1 according to the first embodiment described above can also be achieved with the photodetection device 1 according to any one of Modifications 1 to 4 of the third embodiment.

### [Fourth Embodiment]

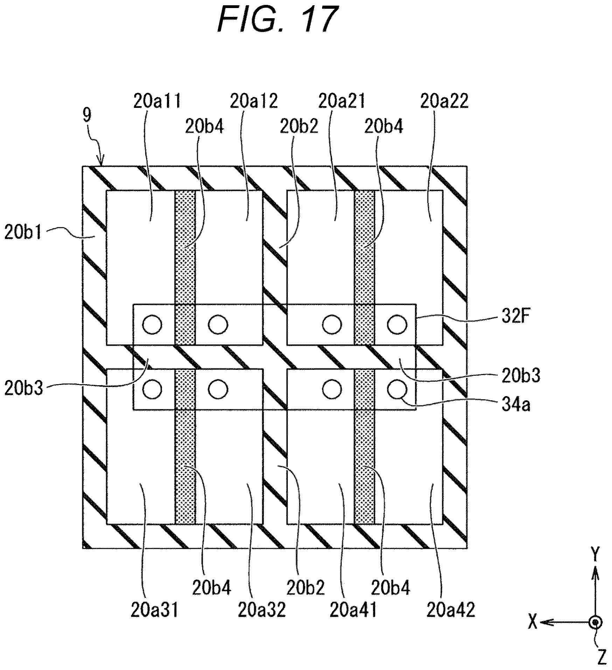

A fourth embodiment of the present technology illustrated in Fig. 17 is described below. A photodetection device 1 according to the fourth embodiment differs from the photodetection device 1 according to the second embodiment described above in the separation regions 20b, and the other aspects of the configuration of the photodetection device 1 are basically similar to those of the photodetection device 1 according to the second embodiment described above. Note that the components already described are denoted by the same reference signs, and explanation of them is not made herein.

In the photodetection device 1 illustrated in Fig. 17, separation regions 20b1, 20b2, and 20b3 are full trench separation regions. Separation regions 20b4 are combinations of a full trench separation region and a diffusion separation region.

### <<Principal Effects of the Fourth Embodiment>>

Effects similar to those of the photodetection device 1 according to the second embodiment described above can also be achieved with the photodetection device 1 according to the fourth embodiment.

### <<Modifications of the Fourth Embodiment>>

In the description below, modifications of the fourth embodiment are explained.

### <Modification 1>

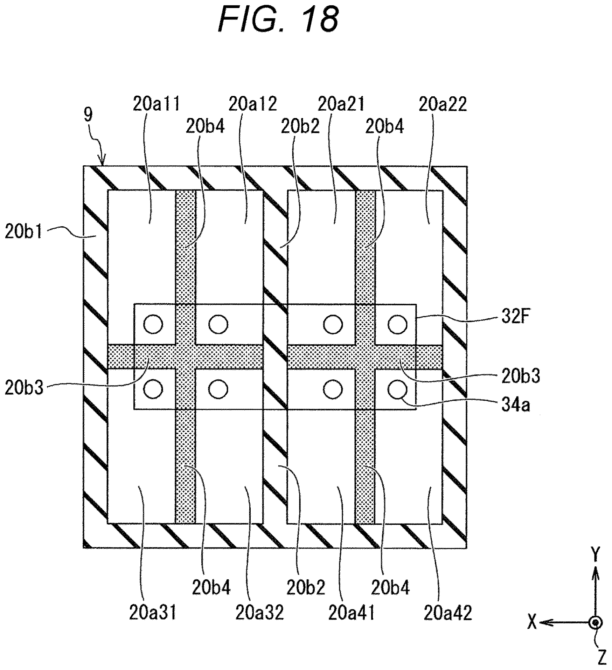

In a photodetection device 1 illustrated in Fig. 18, the separation regions 20b1 and 20b2 are full trench separation regions. The separation regions 20b3 and 20b4 are combinations of a full trench separation region and a diffusion separation region. The separation region 20b2 separates four sub-cell regions 20a21, 20a22, 20a41, and 20a42 on the right side of the drawing, from four sub-cell regions 20a11, 20a12, 20a31, and 20a32 on the left side of the drawing.

### <Modification 2>

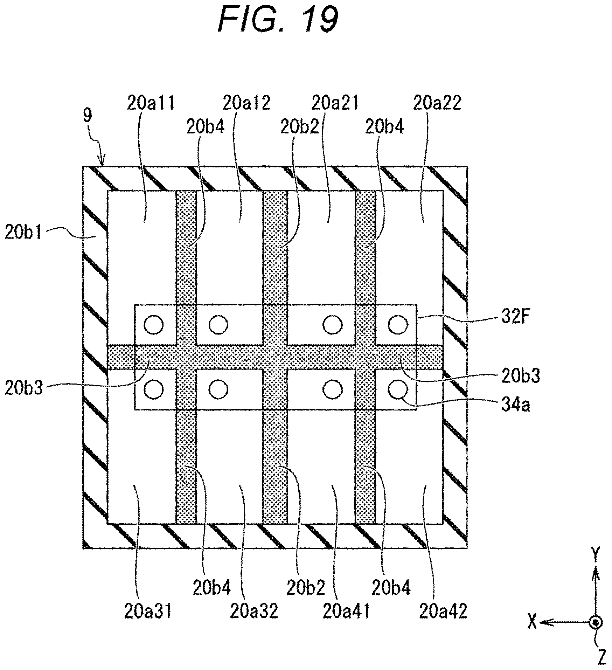

In a photodetection device 1 illustrated in Fig. 19, the separation region 20b1 is a full trench separation region. The separation regions 20b2, 20b3, and 20b4 are combinations of a full trench separation region and a diffusion separation region.

### <Modification 3>

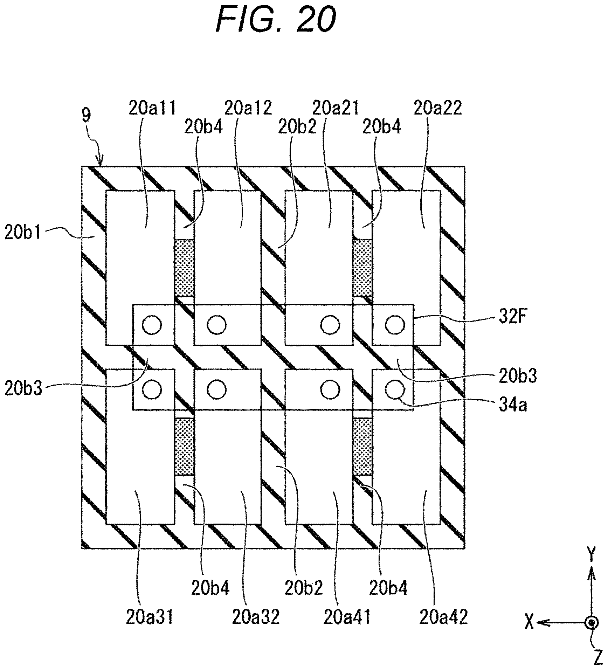

In a photodetection device 1 illustrated in Fig. 20, the separation regions 20b1, 20b2, and 20b3 are full trench separation regions. In each separation region 20b4, a central portion in the Y direction is a combination of a full trench separation region and a diffusion separation region, and the portions other than the central portion are full trench separation regions.

### <Modification 4>

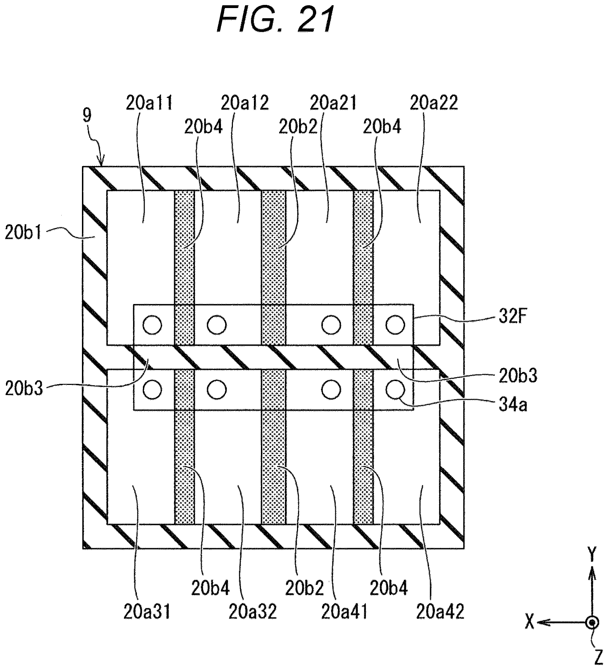

In a photodetection device 1 illustrated in Fig. 21, the separation regions 20b1 and 20b3 are full trench separation regions. The separation regions 20b2 and 20b4 are combinations of a full trench separation region and a diffusion separation region. The separation region 20b3 separates the four sub-cell regions 20a11, 20a12, 20a21, and 20a22 on the upper side of the drawing, from the four sub-cell regions 20a31, 20a32, 20a41, and 20a42 on the lower side of the drawing.

### <Modification 5>

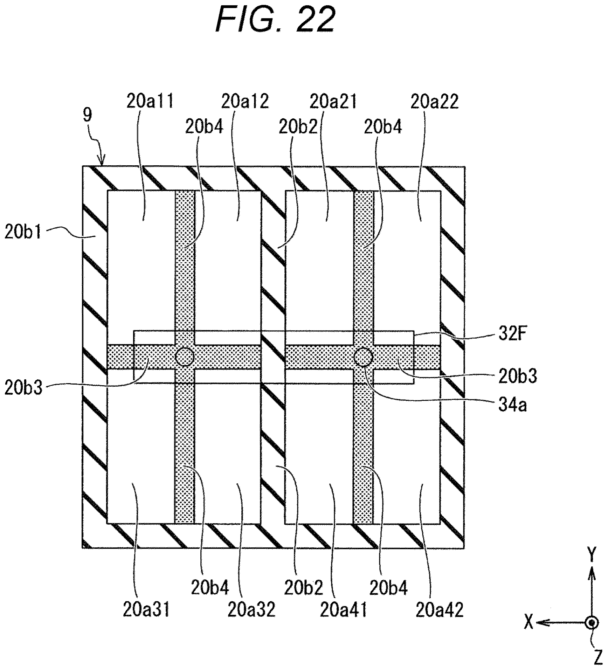

In a photodetection device 1 illustrated in Fig. 22, the separation regions 20b1 and 20b2 are full trench separation regions. The separation regions 20b3 and 20b4 are combinations of a full trench separation region and a diffusion separation region. The separation region 20b2 separates the four sub-cell regions 20a21, 20a22, 20a41, and 20a42 on the right side of the drawing, from the four sub-cell regions 20a11, 20a12, 20a31, and 20a32 on the left side of the drawing.

Also, in the photodetection device 1 illustrated in Fig. 22, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 6>

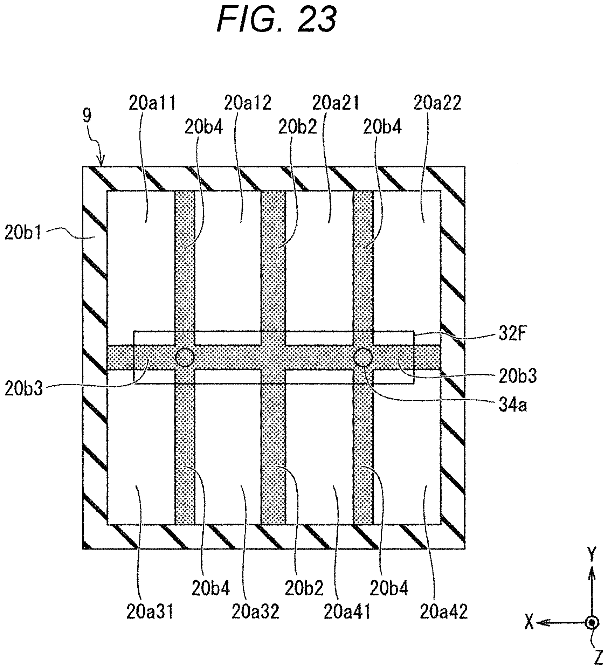

In a photodetection device 1 illustrated in Fig. 23, the separation region 20b1 is a full trench separation region. The separation regions 20b2, 20b3, and 20b4 are combinations of a full trench separation region and a diffusion separation region.

Also, in the photodetection device 1 illustrated in Fig. 23, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 7>

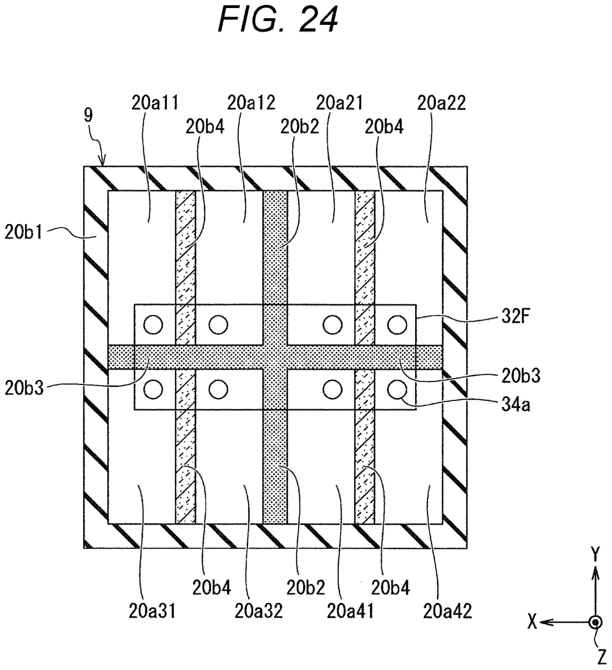

In a photodetection device 1 illustrated in Fig. 24, the separation region 20b1 is a full trench separation region. The separation regions 20b2 and 20b3 are combinations of a full trench separation region and a diffusion separation region. The separation regions 20b4 are diffusion separation regions.

### <Modification 8>

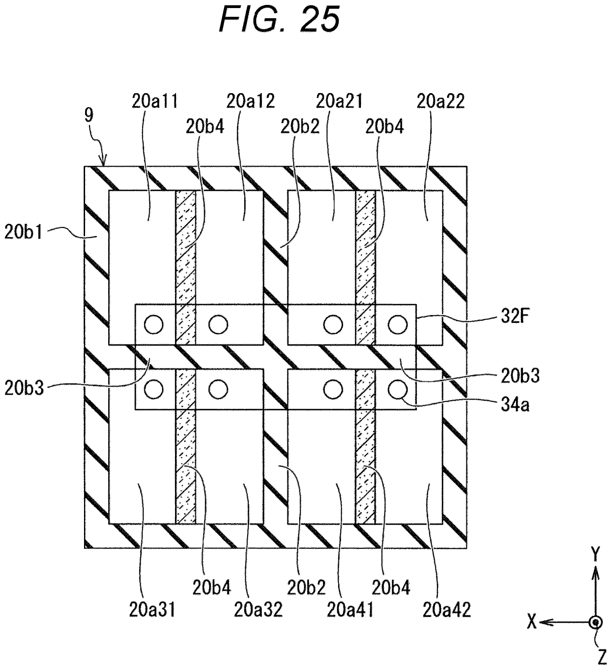

In a photodetection device 1 illustrated in Fig. 25, the separation regions 20b1, 20b2, and 20b3 are full trench separation regions. The separation regions 20b4 are diffusion separation regions.

### <Modification 9>

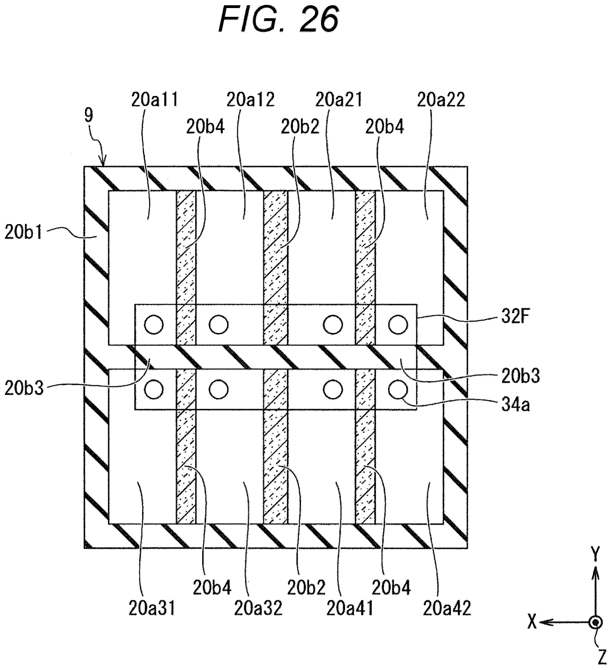

In a photodetection device 1 illustrated in Fig. 26, the separation regions 20b1 and 20b3 are full trench separation regions. The separation regions 20b2 and 20b4 are diffusion separation regions. The separation region 20b3 separates the four sub-cell regions 20a11, 20a12, 20a21, and 20a22 on the upper side of the drawing, from the four sub-cell regions 20a31, 20a32, 20a41, and 20a42 on the lower side of the drawing.

### <Modification 10>

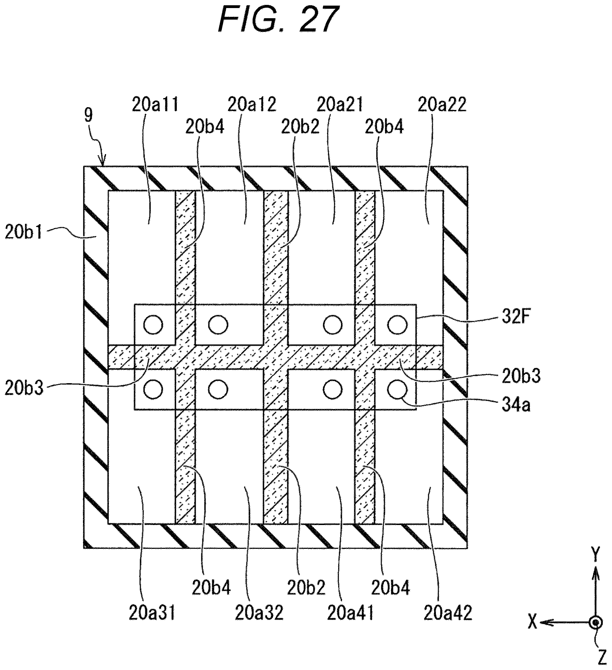

In a photodetection device 1 illustrated in Fig. 27, the separation region 20b1 is a full trench separation region. The separation regions 20b2, 20b3, and 20b4 are diffusion separation regions.

### <Modification 11>

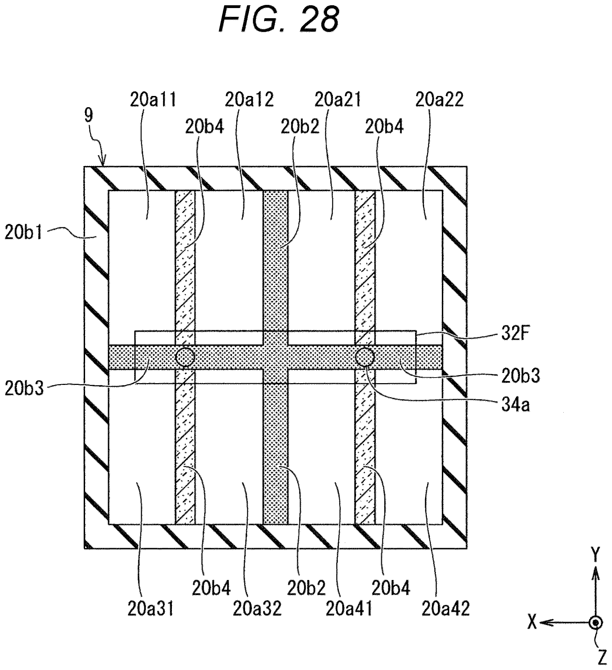

In a photodetection device 1 illustrated in Fig. 28, the separation region 20b1 is a full trench separation region. The separation regions 20b2 and 20b3 are combinations of a full trench separation region and a diffusion separation region. The separation regions 20b4 are diffusion separation regions.

Also, in the photodetection device 1 illustrated in Fig. 28, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 12>

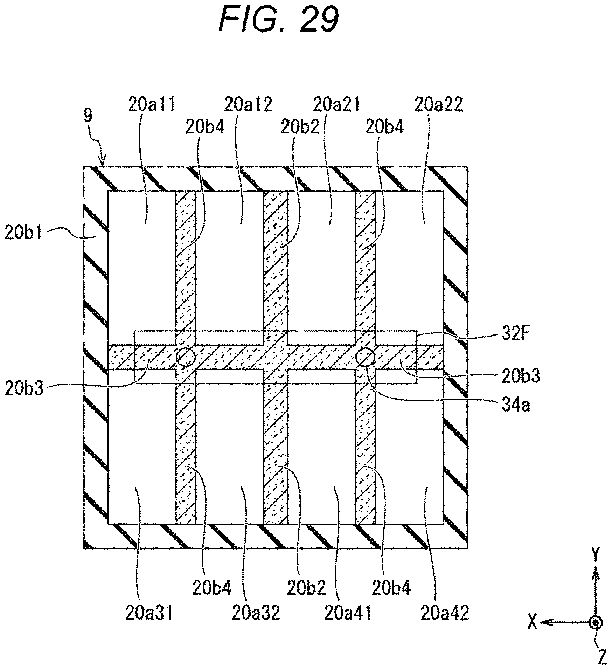

In a photodetection device 1 illustrated in Fig. 29, the separation region 20b1 is a full trench separation region. The separation regions 20b2, 20b3, and 20b4 are diffusion separation regions.

Also, in the photodetection device 1 illustrated in Fig. 29, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 13>

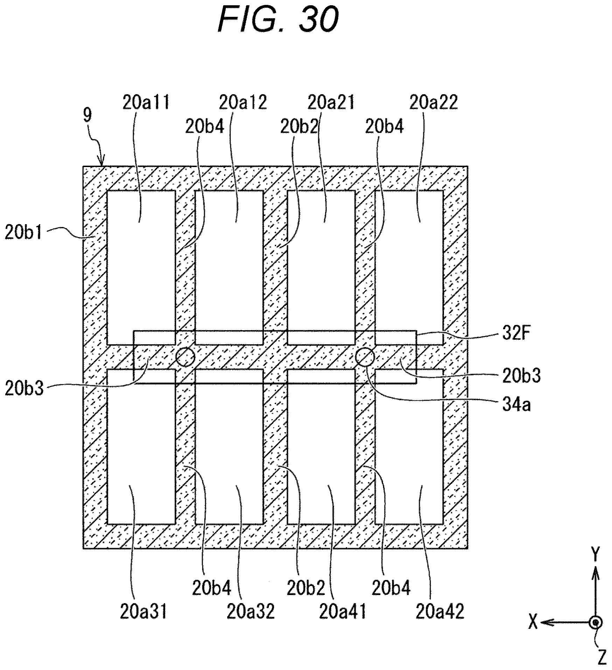

In a photodetection device 1 illustrated in Fig. 30, all the separation regions 20b1, 20b2, 20b3, and 20b4 are diffusion separation regions.

Also, in the photodetection device 1 illustrated in Fig. 30, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 14>

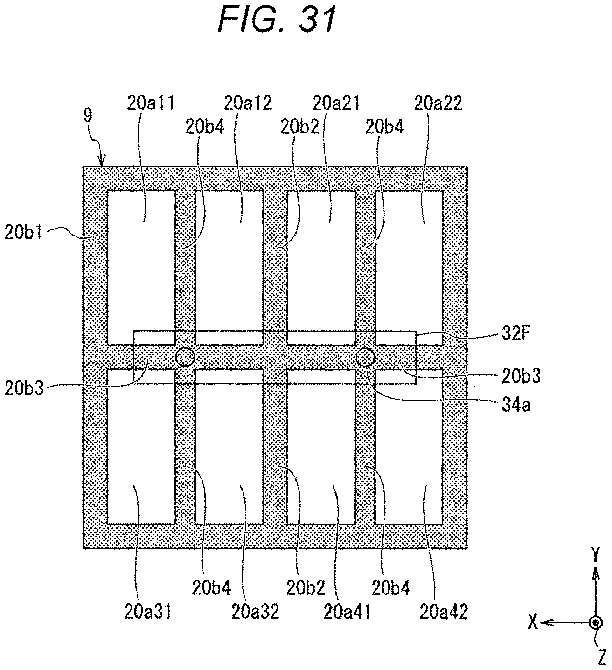

In a photodetection device 1 illustrated in Fig. 31, all the separation regions 20b1, 20b2, 20b3, and 20b4 are combinations of a full trench separation region and a diffusion separation region.

Also, in the photodetection device 1 illustrated in Fig. 31, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 15>

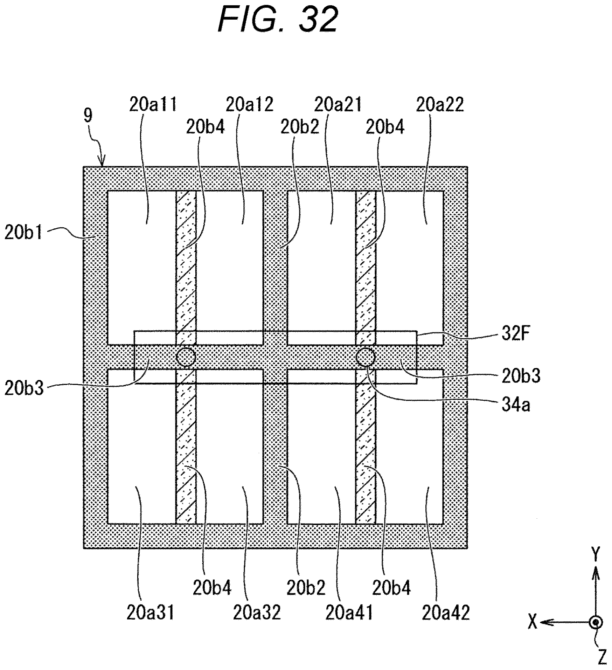

In a photodetection device 1 illustrated in Fig. 32, the separation regions 20b1, 20b2, and 20b3 are combinations of a full trench separation region and a diffusion separation region. The separation regions 20b4 are diffusion separation regions.

Also, in the photodetection device 1 illustrated in Fig. 32, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 16>

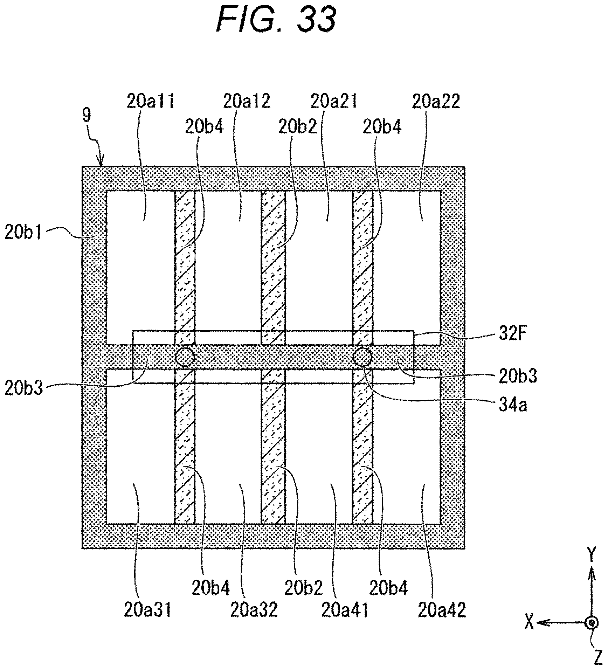

In a photodetection device 1 illustrated in Fig. 33, the separation regions 20b1 and 20b3 are combinations of a full trench separation region and a diffusion separation region. The separation regions 20b2 and 20b4 are diffusion separation regions. The separation region 20b3 separates the four sub-cell regions 20a11, 20a12, 20a21, and 20a22 on the upper side of the drawing, from the four sub-cell regions 20a31, 20a32, 20a41, and 20a42 on the lower side of the drawing.

Also, in the photodetection device 1 illustrated in Fig. 33, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <Modification 17>

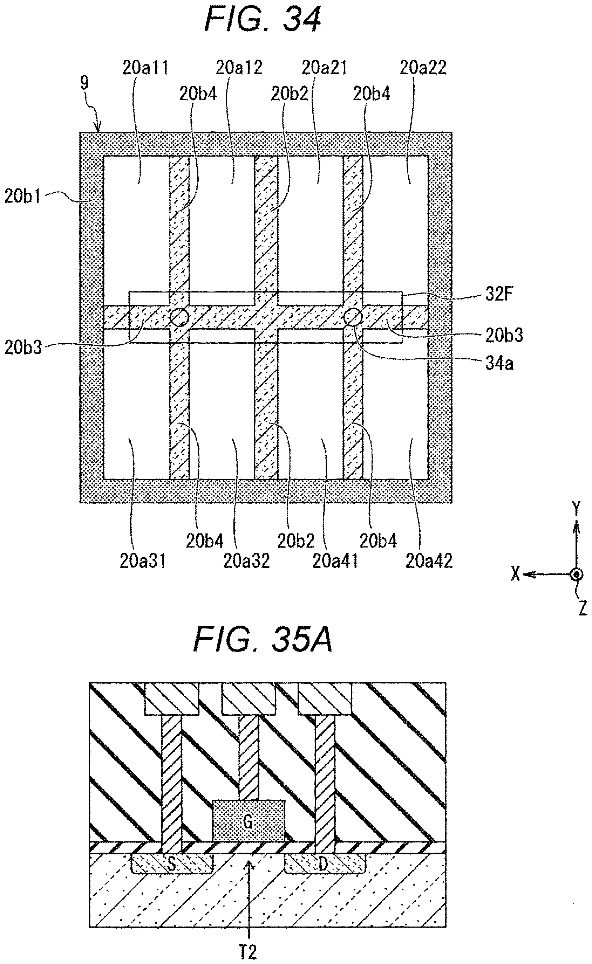

In a photodetection device 1 illustrated in Fig. 34, the separation region 20b1 is a combination of a full trench separation region and a diffusion separation region. The separation regions 20b2, 20b3, and 20b4 are diffusion separation regions.

Also, in the photodetection device 1 illustrated in Fig. 34, two charge accumulation regions FD are provided in one pixel set 9. More specifically, one charge accumulation region FD is provided in the four sub-cell regions 20a21, 20a22, 20a41, and 20a42 on the right side of the drawing, and one charge accumulation region FD is provided in the four sub-cell regions 20a11, 20a12, 20a31, and 20a32 on the left side of the drawing. Each of the charge accumulation regions FD is provided in the vicinity of an intersection of the separation region 20b3 and a separation region 20b4. In other words, the charge accumulation regions FD are provided at the center of the pixel set 9 in a planar view in the column direction (Y direction), and are provided at positions away from the center of the pixel set 9 in a planar view in the row direction (X direction). In the column direction (Y direction), the charge accumulation regions FD are provided at the center of the pixel set 9 in a planar view. Therefore, the dimension of the short side (each side in the Y direction) of the first pad 32F is smaller than that in a case where eight charge accumulation regions FD are provided in one pixel set 9.

### <<Principal Effects of the Modifications of the Fourth Embodiment>>

Effects similar to those of the photodetection device 1 according to the second embodiment described above can also be achieved with the photodetection device 1 according to any one of Modifications 1 to 17 of the fourth embodiment.

### [Fifth Embodiment]

A fifth embodiment of the present technology illustrated in Figs. 35A to 35D is described below. A photodetection device 1 according to the fifth embodiment differs from the photodetection device 1 according to the first embodiment described above in the transistors T2, and the other aspects of the configuration of the photodetection device 1 are basically similar to those of the photodetection device 1 according to the first embodiment described above. Note that the components already described are denoted by the same reference signs, and explanation of them is not made herein.

In the first embodiment described above, the transistors T2 provided in the second semiconductor layer 50 are transistors of the same type as the transistors T1 provided in the first semiconductor layer 20, but the present embodiment is not limited to this. The transistors T2 may be transistors of a different type from the transistors T1.

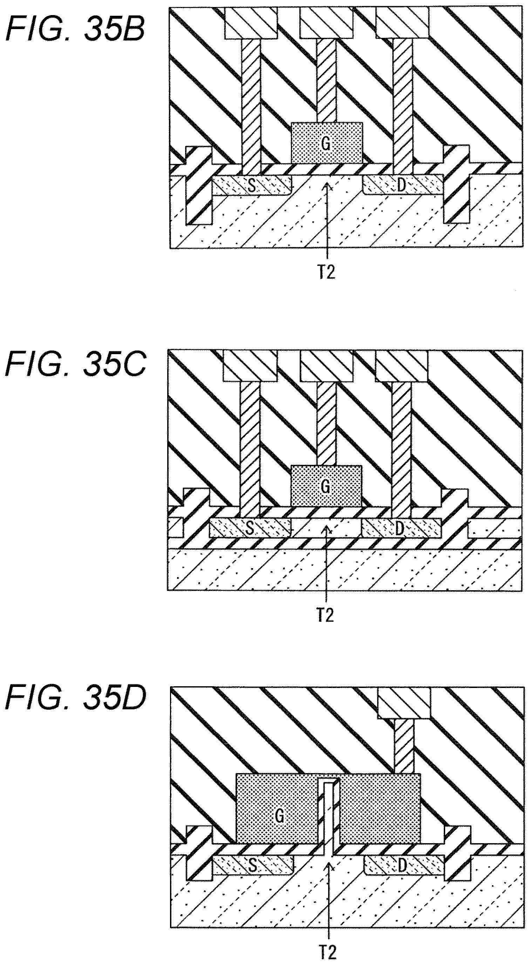

The transistors T2 may be any transistors that are of a different type from the transistors T1. For example, as illustrated in Fig. 35A, each transistor T2 may be a planar transistor that is not separated by a shallow trench. Alternatively, for example, as illustrated in Fig. 35B, each transistor T2 may be a planar transistor that is separated by a shallow trench. Further, for example, each transistor T2 may be an FD SOI transistor, as illustrated in Fig. 35C. Alternatively, for example, each transistor T2 may be a Fin FET transistor, as illustrated in Fig. 35D.

### <<Principal Effects of the Fifth Embodiment>>

Effects similar to those of the photodetection device 1 according to the first embodiment described above can also be achieved with the photodetection device 1 according to the fifth embodiment.

Further, since the present technology involves a plurality of semiconductor layers such as the first semiconductor layer 20, the second semiconductor layer 50, and the third semiconductor layer 80, it is possible to adopt a different manufacturing method for each second semiconductor layer. Accordingly, transistors of a more preferable type can be selected for the transistors to be provided in each semiconductor layer. For example, since the transistors T2 provided in the second semiconductor layer 50 constitutes the readout circuit 15, it is possible to select transistors of a more preferable type for the readout circuit 15, and a method for manufacturing the transistors.

### [Sixth Embodiment]

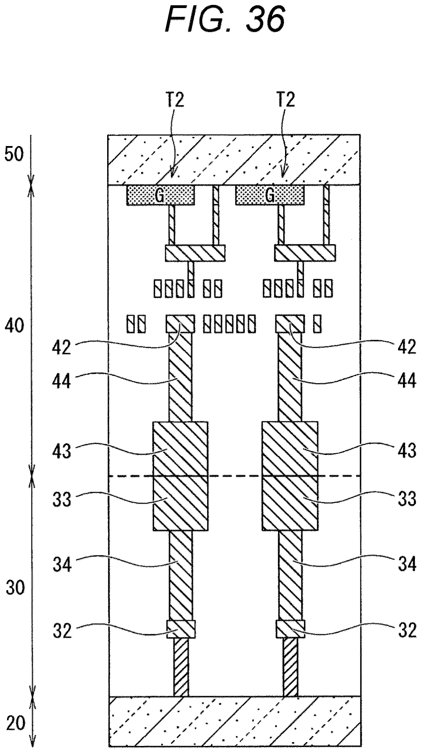

A sixth embodiment of the present technology illustrated in Fig. 36 is described below. A photodetection device 1 according to the sixth embodiment differs from the photodetection device 1 according to the first embodiment described above in the bonding portions (pads), and the other aspects of the configuration of the photodetection device 1 are basically similar to those of the photodetection device 1 according to the first embodiment described above. Note that the components already described are denoted by the same reference signs, and explanation of them is not made herein.

As illustrated in Fig. 36, each of the second pads 33F and the fourth pads 33G included in the second wiring line group 33 is integrally provided together with a via 34 by a dual damascene method. Likewise, each of the third pads 43F and the fifth pads 43G is integrally provided together with a via 34 by a dual damascene method.

### <<Principal Effects of the Sixth Embodiment>>

Effects similar to those of the photodetection device 1 according to the first embodiment described above can also be achieved with the photodetection device 1 according to the sixth embodiment.

### <<Modification of the Sixth Embodiment>>

In the description below, a modification of the sixth embodiment is explained.

### <Modification 1>

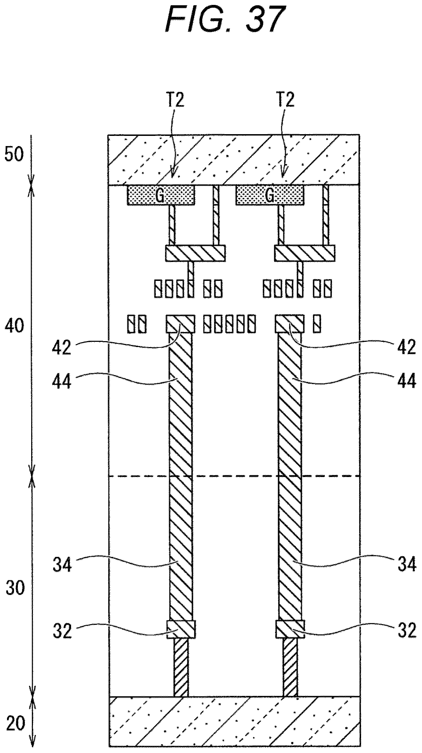

In the bonding portions of a photodetection device 1 according to Modification 1 of the sixth embodiment illustrated in Fig. 37, the second pads 33F, the fourth pads 33G, the third pads 43F, and the fifth pads 43G are not provided, and the vias 34 and the vias 44 are directly connected. The vias 34 and the vias 44 are provided by a single damascene method.

Effects similar to those of the photodetection device 1 according to the first embodiment described above can also be achieved with the photodetection device 1 according to Modification 1 of the sixth embodiment.

Further, since the second pads 33F, the fourth pads 33G, the third pads 43F, and the fifth pads 43G are not provided in the photodetection device 1 according to Modification 1 of the sixth embodiment, it is possible to further prevent elongation of the electrical path from each charge accumulation region FD to the gate electrode of each corresponding amplification transistor AMP.

### [Seventh Embodiment]

### <1. Example Application to an Electronic Apparatus>

Next, an electronic apparatus 100 according to a seventh embodiment of the present technology illustrated in Fig. 38 is described. The electronic apparatus 100 includes a solid-state imaging device 101, an optical lens 102, a shutter device 103, a drive circuit 104, and a signal processing circuit 105. The electronic apparatus 100 is not limited to this, but is an electronic apparatus such as a camera, for example. Furthermore, the electronic apparatus 100 includes the photodetection device 1 described above as the solid-state imaging device 101.

The optical lens (optical system) 102 forms an image of image light (incident light 106) from the object on the imaging surface of the solid-state imaging device 101. As a result, signal charges are accumulated in the solid-state imaging device 101 over a certain period of time. The shutter device 103 controls a light irradiation period and a light shielding period for the solid-state imaging device 101. The drive circuit 104 supplies a drive signal for controlling a transfer operation of the solid-state imaging device 101 and a shutter operation of the shutter device 103. In accordance with a drive signal (a timing signal) supplied from the drive circuit 104, the solid-state imaging device 101 performs signal transfer. The signal processing circuit 105 performs various kinds of signal processing on a signal (pixel signal) that is output from the solid-state imaging device 101. A video signal subjected to the signal processing is stored into a storage medium such as a memory, or is output to a monitor.

With such a configuration, the electronic apparatus 100 includes the photodetection device 1, in which an increase in the capacitance Cfd of the charge accumulation region FD is prevented, as the solid-state imaging device 101, and thus, it is possible to prevent a decrease in the amplitude of the voltage supplied to the gate electrode of the amplification transistor AMP. Thus, a decrease in conversion efficiency can be prevented.

Note that the electronic apparatus 100 is not necessarily a camera, and may be some other electronic apparatus. For example, the electronic apparatus 100 may be an imaging device such as a camera module for a mobile device such as a mobile phone.

Furthermore, the electronic apparatus 100 can include, as the solid-state imaging device 101, the photodetection device 1 according to any one of the first to sixth embodiments and the modifications thereof, or the photodetection device 1 according to a combination of at least two of the first to sixth embodiments and the modifications thereof.

### <2. Example Application to a Mobile Structure>

The technology according to the present disclosure (the present technology) can be applied to various products. For example, the technology of the present disclosure may be achieved in the form of a device to be mounted on a mobile structure of any kind, such as an automobile, an electric vehicle, a hybrid electric vehicle, a motorcycle, a bicycle, a personal mobility, an airplane, a drone, a vessel, or a robot.

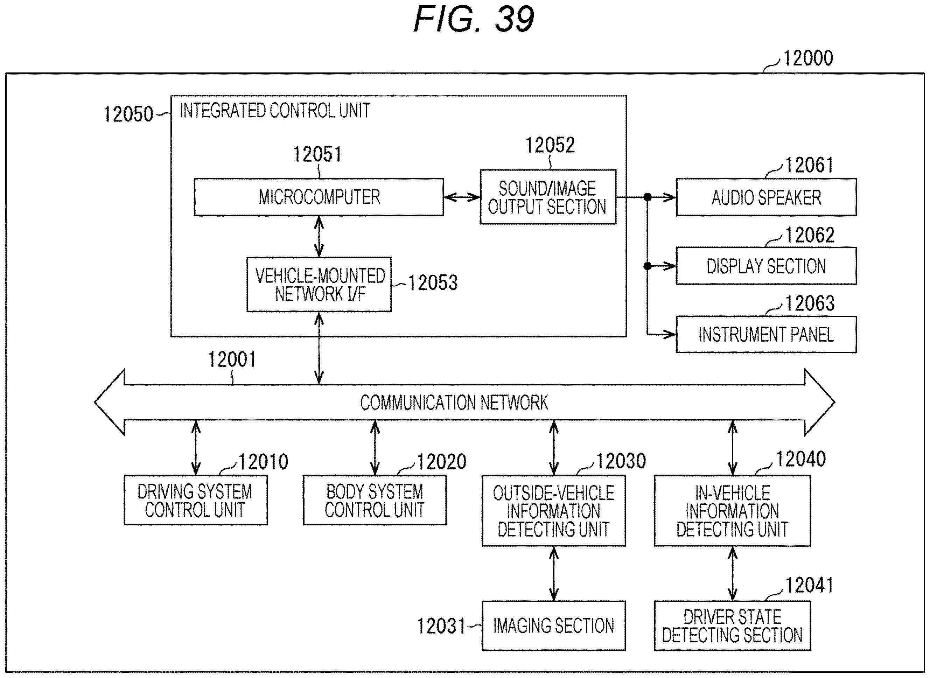

Fig. 39 is a block diagram illustrating an example of a schematic configuration of a vehicle control system that is an example of a mobile structure control system to which the technology according to the present disclosure is applied.

The vehicle control system 12000 includes a plurality of electronic control units connected to each other via a communication network 12001. In the example illustrated in Fig. 39, the vehicle control system 12000 includes a driving system control unit 12010, a body system control unit 12020, an outside-vehicle information detecting unit 12030, an in-vehicle information detecting unit 12040, and an integrated control unit 12050. Also, a microcomputer 12051, a sound/image output section 12052, and a vehicle-mounted network interface (I/F) 12053 are illustrated as the functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

Furthermore, the microcomputer 12051 is capable of outputting a control command to the body system control unit 12020 on the basis of the information regarding the outside of the vehicle obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example illustrated in Fig. 39, an audio speaker 12061, a display section 12062, and an instrument panel 12063 are illustrated as the output apparatus. The display section 12062 may, for example, include at least one of an on-board display and a head-up display.

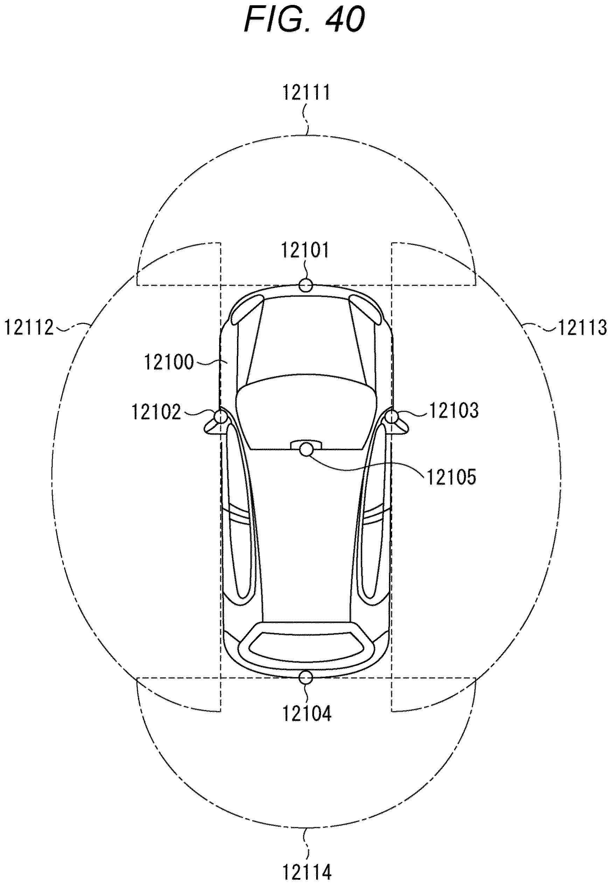

Fig. 40 is a diagram illustrating an example of the installation positions of the imaging sections 12031.

In Fig. 40, a vehicle 12100 includes imaging sections 12101, 12102, 12103, 12104, and 12105 as the imaging sections 12031.

The imaging sections 12101, 12102, 12103, 12104, and 12105 are disposed at positions such as a front nose, a side mirror, a rear bumper, a back door, and an upper portion of a windshield in the interior of a vehicle 12100, for example. The imaging section 12101 provided to the front nose and the imaging section 12105 provided to the upper portion of the windshield within the interior of the vehicle obtain mainly an image of the front of the vehicle 12100. The imaging sections 12102 and 12103 disposed at the side mirrors mainly obtain images on the sides of the vehicle 12100. The imaging section 12104 provided to the rear bumper or the back door obtains mainly an image of the rear of the vehicle 12100. The forward images obtained by the imaging sections 12101 and 12105 are used mainly to detect a preceding vehicle, a pedestrian, an obstacle, a traffic signal, a traffic sign, a lane, or the like.

Note that Fig. 40 illustrates an example of the imaging ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

An example of the vehicle control system to which the technology according to the present disclosure can be applied has been described above. The technology according to the present disclosure can be applied to the imaging section 12031 in the configuration described above. Specifically, the photodetection device 1 illustrated in Fig. 4A and others can be applied to the imaging section 12031. By applying the technology according to the present disclosure to the imaging section 12031, it is possible to prevent an increase in the capacitance Cfd of the charge accumulation region FD, and a decrease in the amplitude of the voltage to be supplied to the gate electrode of the amplification transistor AMP. Thus, conversion efficiency can be increased, and the amplitude of the voltage transmitting signal charges to the vertical signal line can be increased.

### <3. Example Application to an Endoscopic Surgery System>

The technology according to the present disclosure (the present technology) can be applied to various products. For example, the technology according to the present disclosure may be applied to an endoscopic surgery system.

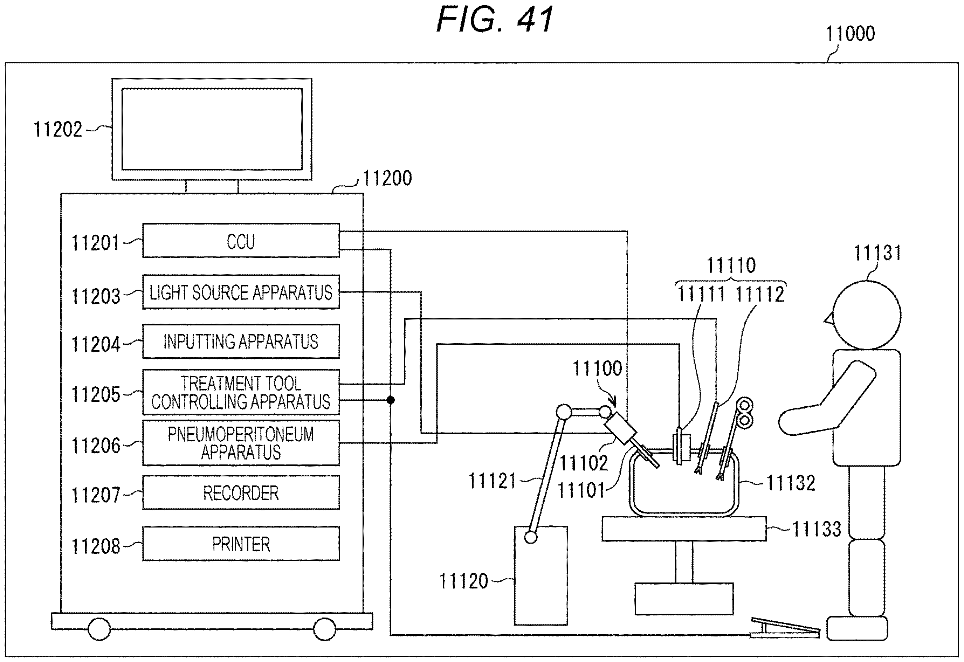

Fig. 41 is a diagram illustrating an example of a schematic configuration of an endoscopic surgery system to which the technology according to the present disclosure (the present technology) can be applied.

Fig. 41 illustrates a state in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as a light emitting diode (LED), for example, and supplies irradiation light for imaging a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

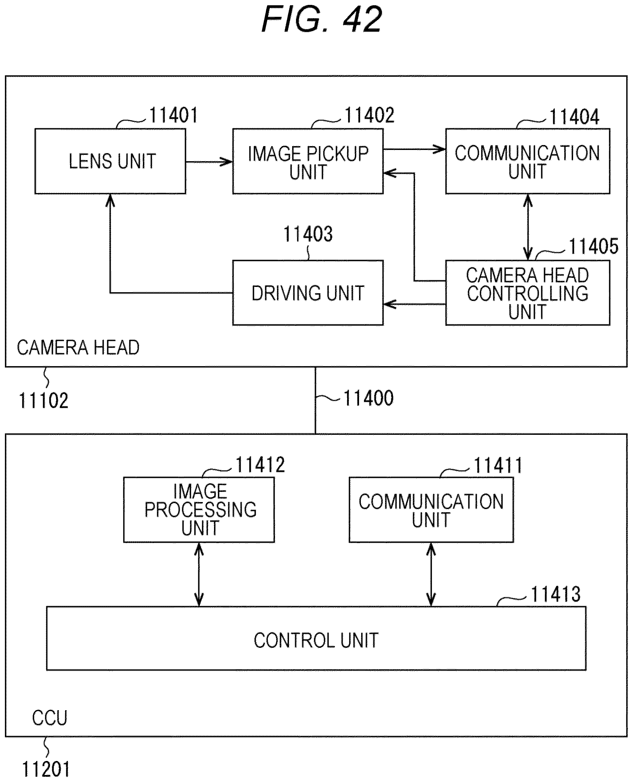

Fig. 42 is a block diagram illustrating an example of the functional configurations of the camera head 11102 and the CCU 11201 illustrated in Fig. 41.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The image pickup unit 11402 includes an image pickup element. The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. Alternatively, the image pickup unit 11402 may include a pair of image pickup elements for acquiring right-eye and left-eye image signals corresponding to three-dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 11131, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

An example of the endoscopic surgery system to which the technology according to the present disclosure can be applied has been described above. The technology according to the present disclosure may be applied to the image pickup unit 11402 of the camera head 11102 in the configuration described above. Specifically, the photodetection device 1 illustrated in Fig. 4A and others can be applied to the image pickup unit 11402. By applying the technology according to the present disclosure to the image pickup unit 11402, it is possible to prevent an increase in the capacitance Cfd of the charge accumulation region FD, and a decrease in the amplitude of the voltage to be supplied to the gate electrode of the amplification transistor AMP. Thus, conversion efficiency can be increased, and the amplitude of the voltage transmitting signal charges to the vertical signal line can be increased.

Note that an endoscopic surgery system has been described as an example herein, but the technology according to the present disclosure may be applied to a microscopic surgery system or the like, for example.

### [Other Embodiments]

As described above, the present technology has been described by way of the first to seventh embodiments, but it should not be understood that the description and drawings constituting a part of this disclosure limit the present technology. Various alternative embodiments, examples, and operation techniques will be apparent to those skilled in the art from this disclosure.

For example, the technical ideas described in the first to seventh embodiments and the modifications thereof can be combined with each other. For example, various combinations in accordance with the respective technical ideas are possible, such as application of the structure of the transistor of the fifth embodiment described above to the second embodiment, and application of the structure of the bonding portions of the sixth embodiment to the second embodiment.

Furthermore, the present technology can be applied to all kinds of photodetection devices including not only the above-described solid-state imaging device as an image sensor but also a ranging sensor also called a time of flight (ToF) sensor that measures distances, and the like. A ranging sensor is a sensor that emits irradiation light toward an object, detects reflected light that is the irradiation light reflected by a surface of the object, and calculates the distance to the object on the basis of a flight time since the emission of the irradiation light till the reception of the reflected light. As the structure of this ranging sensor, a structure formed with a first conductor and a second conductor described above can be adopted. Also, the present technology can be applied to a semiconductor device other than the photodetection device 1. Further, the materials mentioned as the materials forming the components described above may contain additives, impurities, or the like, for example.

Further, in the above embodiments, the separation structure illustrated in Fig. 13B is referred to as a "combination of a full trench separation region and a diffusion separation region", but may also be referred to as a "combination of a trench separation region and a diffusion separation region" or a "combination of a deep trench separation region and a diffusion separation region".

In this manner, it is a matter of course that the present technology includes various embodiments and the like not described herein. Therefore, the technical scope of the present technology is defined only by the matters used to define the inventions disclosed in the claims considered appropriate from the above description.

Furthermore, the effects described herein are mere examples and are not restrictive, and there may be additional effects.

Note that the present technology may also have the following configurations.
(1) A photodetection device including
   a stack structure in which a first semiconductor layer, a first wiring layer, a second wiring layer, and a second semiconductor layer are stacked in this order,
   the first semiconductor layer including: a cell region in which a photoelectric conversion element is formed; a charge accumulation region; and a transfer transistor that is provided for each photoelectric conversion element, and is capable of transferring a signal charge generated by the photoelectric conversion element to the charge accumulation region,
   the first wiring layer including: a first wiring line group; and a second wiring line group stacked on the first wiring line group, with an insulating film being interposed in between,
   the first wiring line group being a wiring line group located closest to the first semiconductor layer, the first wiring line group including a first pad, a reference potential line, and a gate control line provided at intervals in a horizontal direction,
   the second wiring line group including a second pad that faces a surface of the first wiring layer on a side of the second wiring layer, and is electrically connected to the first pad,
   the first wiring layer including: a first via having one end connected to the charge accumulation region, and the other end connected to the first pad; a second via having one end connected to the cell region, and the other end connected to the reference potential line; and a third via having one end connected to a gate electrode of the transfer transistor, and the other end connected to the gate control line.
(2) The photodetection device of (1), in which
   the first semiconductor layer includes a plurality of sets each including four of the cell regions arranged in two rows and two columns,
   the sets are rectangular in a planar view,
   at least one of the charge accumulation regions, one of the first pads, and one of the second pads are provided for each of the sets, and
   the first pad is disposed at a position overlapping a center of the set in a planar view.
(3) The photodetection device of (2), in which the second pad is disposed at a position overlapping the center of the set in a planar view.
(4) The photodetection device of (2) or (3), in which
   the second wiring layer includes a third pad that faces a surface of the second wiring layer on a side of the first wiring layer, and is bonded to the second pad,
   the second semiconductor layer includes an amplification transistor,
   the amplification transistor includes a gate electrode, and is capable of outputting a voltage corresponding to a voltage to be input to the gate electrode, and
   the gate electrode of the amplification transistor is electrically connected to the third pad.
(5) The photodetection device of (4), in which the gate electrode of the amplification transistor is located at a position overlapping the first pad in a planar view.
(6) The photodetection device of any one of (2) to (5), in which
   the second wiring line group includes a fourth pad that faces the surface of the first wiring layer on the side of the second wiring layer, and is electrically connected to the reference potential line, and
   the fourth pad is disposed at a position overlapping a corner portion of the set in a planar view.
(7) The photodetection device of (6), in which the second wiring layer includes a fifth pad that faces the surface of the second wiring layer on the side of the first wiring layer, and is bonded to the fourth pad.
(8) The photodetection device of any one of (2) to (7), in which two of the photoelectric conversion elements are formed for each one of the cell regions.
(9) The photodetection device of any one of (1) to (8), in which the first wiring layer includes only the first wiring line group and the second wiring line group as wiring line groups.
(10) The photodetection device of any one of (1) to (9), further including a stack structure in which the first semiconductor layer, the first wiring layer, the second wiring layer, the second semiconductor layer, a third wiring layer, a fourth wiring layer, and a third semiconductor layer are stacked in this order.
(11) An electronic apparatus including:
   a photodetection device; and an optical system that causes the photodetection device to form an image with image light from an object,
   the photodetection device including
   a stack structure in which a first semiconductor layer, a first wiring layer, a second wiring layer, and a second semiconductor layer are stacked in this order,
   the first semiconductor layer including: a cell region in which a photoelectric conversion element is formed; a charge accumulation region; and a transfer transistor that is provided for each photoelectric conversion element, and is capable of transferring a signal charge generated by the photoelectric conversion element to the charge accumulation region,
   the first wiring layer including: a first wiring line group; and a second wiring line group stacked on the first wiring line group, with an insulating film being interposed in between,
   the first wiring line group being a wiring line group located closest to the first semiconductor layer, the first wiring line group including a first pad, a reference potential line, and a gate control line provided at intervals in a horizontal direction,
   the second wiring line group including a second pad that faces a surface of the first wiring layer on a side of the second wiring layer, and is electrically connected to the first pad,
   the first wiring layer including: a first via having one end connected to the charge accumulation region, and the other end connected to the first pad; a second via having one end connected to the cell region, and the other end connected to the reference potential line; and a third via having one end connected to a gate electrode of the transfer transistor, and the other end connected to the gate control line.

The scope of the present technology is not limited to the exemplary embodiments illustrated in the drawings and described above, but includes also all embodiments that produce effects equivalent to the effects that the present technology intends to produce. Further, the scope of the present technology is not limited to the combinations of the features of the invention defined by the claims, and may be defined by any desired combination of specific features among all the disclosed features.

### REFERENCE SIGNS LIST

- 1: Photodetection device
- 2: Semiconductor chip
- 2A: Pixel region
- 2B: Peripheral region
- 3: Pixel
- 4: Vertical drive circuit
- 5: Column signal processing circuit
- 6: Horizontal drive circuit
- 7: Output circuit
- 8: Control circuit
- 9: Pixel set
- 10: Pixel drive line
- 11: Vertical signal line
- 12: Horizontal signal line
- 13: Logic circuit
- 14: Bonding pad
- 15: Readout circuit
- 20: First semiconductor layer
- 20a: Cell region
- 20b: Separation region
- 21: Set
- 30: First wiring layer
- 32: First wiring line group
- 32F: First pad
- 32G: Reference potential line
- 32T: Gate control line
- 33: Second wiring line group
- 33F: Second pad
- 33G: Fourth pad
- 34: Via
- 34a: First via
- 34b: Second via
- 34c: Third via
- 40: Second wiring layer
- 42: Wiring line
- 42: Via
- 42F: First pad
- 43F: Third pad
- 43G: Fifth pad
- 44: Via
- 50: Second semiconductor layer
- 60: Third wiring layer
- 70: Fourth wiring layer
- 80: Third semiconductor layer
- 100: Electronic apparatus
- 101: Solid-state imaging device
- 102: Optical system (optical lens)
- 103: Shutter device
- 104: Drive circuit
- 105: Signal processing circuit
- 106: Incident light
- T1, T2, T3: Transistor

## Claims

1. A photodetection device comprising
a stack structure in which a first semiconductor layer, a first wiring layer, a second wiring layer, and a second semiconductor layer are stacked in this order,
the first semiconductor layer including: a cell region in which a photoelectric conversion element is formed; a charge accumulation region; and a transfer transistor that is provided for each photoelectric conversion element, and is capable of transferring a signal charge generated by the photoelectric conversion element to the charge accumulation region,
the first wiring layer including: a first wiring line group; and a second wiring line group stacked on the first wiring line group, with an insulating film being interposed in between,
the first wiring line group being a wiring line group located closest to the first semiconductor layer, the first wiring line group including a first pad, a reference potential line, and a gate control line provided at intervals in a horizontal direction,
the second wiring line group including a second pad that faces a surface of the first wiring layer on a side of the second wiring layer, and is electrically connected to the first pad,
the first wiring layer including: a first via having one end connected to the charge accumulation region, and another end connected to the first pad; a second via having one end connected to the cell region, and another end connected to the reference potential line; and a third via having one end connected to a gate electrode of the transfer transistor, and another end connected to the gate control line.

2. The photodetection device according to claim 1, wherein
the first semiconductor layer includes a plurality of sets each including four of the cell regions arranged in two rows and two columns,
the sets are rectangular in a planar view,
at least one of the charge accumulation regions, one of the first pads, and one of the second pads are provided for each of the sets, and
the first pad is disposed at a position overlapping a center of the set in a planar view.

3. The photodetection device according to claim 2, wherein the second pad is disposed at a position overlapping the center of the set in a planar view.

4. The photodetection device according to claim 2, wherein
the second wiring layer includes a third pad that faces a surface of the second wiring layer on a side of the first wiring layer, and is bonded to the second pad,
the second semiconductor layer includes an amplification transistor,
the amplification transistor includes a gate electrode, and is capable of outputting a voltage corresponding to a voltage to be input to the gate electrode, and
the gate electrode of the amplification transistor is electrically connected to the third pad.

5. The photodetection device according to claim 4, wherein the gate electrode of the amplification transistor is located at a position overlapping the first pad in a planar view.

6. The photodetection device according to claim 2, wherein
the second wiring line group includes a fourth pad that faces the surface of the first wiring layer on the side of the second wiring layer, and is electrically connected to the reference potential line, and
the fourth pad is disposed at a position overlapping a corner portion of the set in a planar view.

7. The photodetection device according to claim 6, wherein the second wiring layer includes a fifth pad that faces a surface of the second wiring layer on a side of the first wiring layer, and is bonded to the fourth pad.

8. The photodetection device according to claim 2, wherein two of the photoelectric conversion elements are formed for each one of the cell regions.

9. The photodetection device according to claim 1, wherein the first wiring layer includes only the first wiring line group and the second wiring line group as wiring line groups.

10. The photodetection device according to claim 1, further comprising a stack structure in which the first semiconductor layer, the first wiring layer, the second wiring layer, the second semiconductor layer, a third wiring layer, a fourth wiring layer, and a third semiconductor layer are stacked in this order.

11. An electronic apparatus comprising:
a photodetection device; and an optical system that causes the photodetection device to form an image with image light from an object,
the photodetection device including
a stack structure in which a first semiconductor layer, a first wiring layer, a second wiring layer, and a second semiconductor layer are stacked in this order,
the first semiconductor layer including: a cell region in which a photoelectric conversion element is formed; a charge accumulation region; and a transfer transistor that is provided for each photoelectric conversion element, and is capable of transferring a signal charge generated by the photoelectric conversion element to the charge accumulation region,
the first wiring layer including: a first wiring line group; and a second wiring line group stacked on the first wiring line group, with an insulating film being interposed in between,
the first wiring line group being a wiring line group located closest to the first semiconductor layer, the first wiring line group including a first pad, a reference potential line, and a gate control line provided at intervals in a horizontal direction,
the second wiring line group including a second pad that faces a surface of the first wiring layer on a side of the second wiring layer, and is electrically connected to the first pad,
the first wiring layer including: a first via having one end connected to the charge accumulation region, and another end connected to the first pad; a second via having one end connected to the cell region, and another end connected to the reference potential line; and a third via having one end connected to a gate electrode of the transfer transistor, and another end connected to the gate control line.
